# EUROPEAN PATENT APPLICATION

(11) **EP 4 811 811 A1**
(43) Date of publication of application: **23.09.2026**
(21) Application number: 26165683.9
(22) Date of filing: 18.03.2026
(51) Int. Cl.: H04N 25/11, H04N 25/46, H04N 25/773

(54) **PHOTOELECTRIC CONVERSION DEVICE**

(30) Priority: 19.03.2025 JP 2025045387
(71) Applicant: CANON KABUSHIKI KAISHA, Ohta-ku Tokyo 146-8501 (JP)
(72) Inventor: SEKINE, Hiroshi, Ohta-ku, Tokyo 146-8501 (JP)
(74) Representative: TBK

(57) **Abstract**

A photoelectric conversion device (100) includes a plurality of avalanche photodiodes (201-1, 201-2), a first counter (220-1) configured to count a first pulsed signal based on a photon incident on a first avalanche photodiode (201-1) of the plurality of avalanche photodiodes (201-1, 201-2), a second counter (220-2) configured to count a second pulsed signal based on a photon incident on a second avalanche photodiode (201-2) of the plurality of avalanche photodiodes (201-1, 201-2), and a third counter (220-12) configured to count a combined pulsed signal generated by combining the first pulsed signal and the second pulsed signal.

## Description

### TECHNICAL FIELD

The present disclosure relates to a photoelectric conversion device.

### BACKGROUND

Japanese Patent Laid-Open No. 2019-193043 discloses an imaging device having a plurality of pixels. Each of the plurality of pixels includes a counter that counts a signal pulse corresponding to light reception in an avalanche photodiode and outputs a count value.

### SUMMARY

In a photoelectric conversion device such as that disclosed in Japanese Patent Laid-Open No. 2019-193043, there is a case where it is required to further increase the speed of signal processing for a count value.

Accordingly, the present disclosure is directed toward a photoelectric conversion device capable of speeding up signal processing.

The present disclosure in its first aspect provides a photoelectric conversion device as specified in claim 1. Optional features are specified in claims 2 to 15.

Features of the present disclosure will become apparent from the following description of embodiments with reference to the attached drawings. The following description of embodiments is described by way of example.

### BRIEF DESCRIPTION OF THE DRAWINGS

Fig. 1 is a schematic diagram illustrating an overall configuration of a photoelectric conversion device according to a first embodiment.
Fig. 2 is a schematic block diagram illustrating a configuration example of a sensor substrate according to the first embodiment.
Fig. 3 is a schematic block diagram illustrating a configuration example of a circuit substrate according to the first embodiment.
Fig. 4 is a block diagram illustrating a configuration example of a pixel circuit according to the first embodiment.
Fig. 5 is a circuit diagram illustrating a configuration example of the pixel circuit according to the first embodiment.
Fig. 6 is a diagram illustrating an operation of an avalanche photodiode according to the first embodiment.
Fig. 7 is a timing chart illustrating an operation of the photoelectric conversion device according to the first embodiment.
Fig. 8 is a timing chart illustrating an operation of the photoelectric conversion device according to a first modification of the first embodiment.
Fig. 9 is a circuit diagram illustrating a configuration example of the pixel circuit according to a second modification of the first embodiment.
Fig. 10A and Fig. 10B are timing charts illustrating effects of the second modification of the first embodiment.
Fig. 11 is a circuit diagram illustrating a configuration example of the pixel circuit according to a third modification of the first embodiment.
Fig. 12 is a circuit diagram illustrating a configuration example of the pixel circuit according to a second embodiment.
Fig. 13 is a diagram illustrating an operation of the avalanche photodiode according to the second embodiment.
Fig. 14 is a timing chart illustrating an operation of the photoelectric conversion device according to the second embodiment.
Fig. 15 is a block diagram illustrating a configuration example of the pixel circuit according to a modification of the second embodiment.
Fig. 16 is a circuit diagram illustrating a configuration example of the pixel circuit according to the modification of the second embodiment.
Fig. 17 is a timing chart illustrating an operation of the photoelectric conversion device according to the modification of the second embodiment.
Fig. 18 is a block diagram illustrating a configuration example of the pixel circuit according to a third embodiment.
Fig. 19A and Fig. 19B are arrangement diagrams of the pixels according to the third embodiment.
Fig. 20 is a schematic plan view of the pixel according to a fourth embodiment.
Fig. 21 is a block diagram illustrating a configuration example of the pixel circuit according to the fourth embodiment.
Fig. 22 is a circuit diagram illustrating a configuration example of the pixel circuit according to the fourth embodiment.
Fig. 23 is a block diagram of a light detection system according to a fifth embodiment.
Fig. 24 is a block diagram of a light detection system according to a sixth embodiment.
Fig. 25 is a schematic diagram of an endoscopic surgery system according to a seventh embodiment.
Fig. 26 is a schematic diagram of a light detection system according to an eighth embodiment.
Fig. 27A, Fig. 27B, and Fig. 27C are schematic diagrams of movable body according to the eighth embodiment.
Fig. 28 is a flowchart illustrating an operation of the light detection system according to the eighth embodiment.
Fig. 29A and Fig. 29B are diagrams illustrating specific examples of electronic equipment according to a ninth embodiment.
Fig. 30 is a block diagram of equipment according to a tenth embodiment.

### DESCRIPTION OF THE EMBODIMENTS

Hereinafter, embodiments of the present disclosure will be described with reference to the drawings. The same or corresponding elements are denoted by the same reference numerals throughout the several drawings, and the description thereof may be omitted or simplified.

In the embodiments described below, an imaging device will be mainly described as an example of a photoelectric conversion device. However, the photoelectric conversion device to which the technology of each embodiment is applicable is not limited to an imaging device, and may be another device. For example, the technology of each embodiment can also be applied to a ranging device (For example, a device for measuring distance using time of flight (ToF)) and a photometric device (a device for measuring an amount of incident light).

### First Embodiment

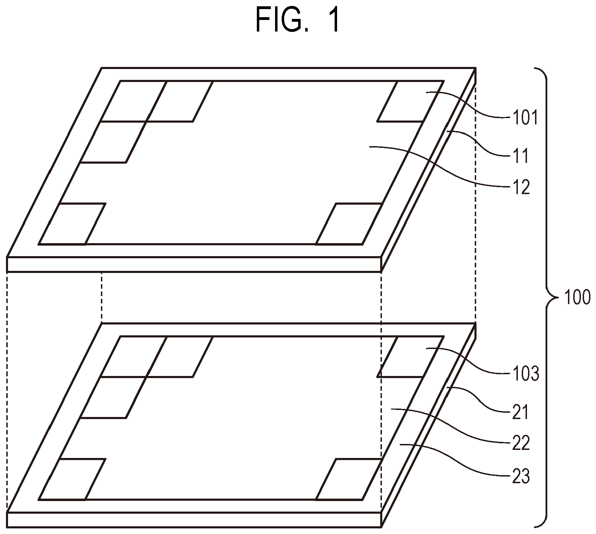

Fig. 1 is a schematic diagram illustrating an overall configuration of the photoelectric conversion device 100 according to the present embodiment. The photoelectric conversion device 100 includes a sensor substrate 11 (first substrate) and a circuit substrate 21 (second substrate) stacked. The sensor substrate 11 and the circuit substrate 21 are electrically connected to each other. The sensor substrate 11 has a pixel region 12 in which a plurality of pixel circuits 101 are arranged to form a plurality of rows and a plurality of columns. The circuit substrate 21 includes a first circuit region 22 in which a plurality of pixel signal processing units 103 are arranged to form a plurality of rows and a plurality of columns, and a second circuit region 23 arranged outside the first circuit region 22. The second circuit region 23 may include a circuit for controlling the plurality of pixel signal processing units 103. The sensor substrate 11 has a light incident surface for receiving incident light and a connection surface opposed to the light incident surface. The sensor substrate 11 is connected to the circuit substrate 21 on the connection surface side. That is, the photoelectric conversion device 100 is a so-called backside illumination type.

In this specification, the term "plan view" refers to a view from a direction perpendicular to a surface opposite to the light incident surface. The cross section indicates a surface in a direction perpendicular to a surface opposite to the light incident surface of the sensor substrate 11. Although the light incident surface may be a rough surface when viewed microscopically, in this case, a plan view is defined with reference to the light incident surface when viewed macroscopically.

In the following description, the sensor substrate 11 and the circuit substrate 21 are diced chips, but the sensor substrate 11 and the circuit substrate 21 are not limited to chips. For example, the sensor substrate 11 and the circuit substrate 21 may be wafers. When the sensor substrate 11 and the circuit substrate 21 are diced chips, the photoelectric conversion device 100 may be manufactured by being diced after being stacked in a wafer state, or may be manufactured by being stacked after being diced.

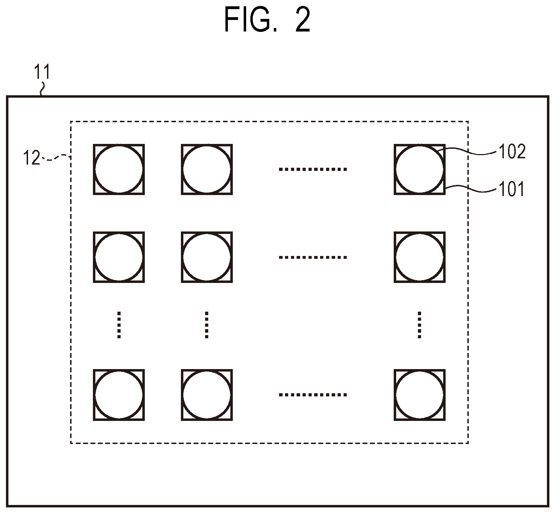

Fig. 2 is a schematic block diagram illustrating a configuration example of the sensor substrate 11. In the pixel region 12, a plurality of pixels 101 are arranged to form a plurality of rows and a plurality of columns. Each of the plurality of pixels 101 includes a photoelectric conversion unit 102 including an avalanche photodiode (hereinafter referred to as APD) as a photoelectric conversion element in the substrate.

Of the charge pairs generated in the APD, the conductivity type corresponding to the charge used as the signal charge is referred to as a first conductivity type. The first conductivity type refers to a conductivity type in which a charge having the same polarity as the signal charge is a majority carrier. Further, a conductivity type opposite to the first conductivity type, that is, a conductivity type in which a majority carrier is a charge having a polarity different from that of a signal charge is referred to as a second conductivity type. In the APD described below, the anode of the APD is set to a fixed potential, and a signal is extracted from the cathode of the APD. Accordingly, the semiconductor region of the first conductivity type is an N-type semiconductor region, and the semiconductor region of the second conductivity type is a P-type semiconductor region. Note that the cathode of the APD may have a fixed potential and a signal may be extracted from the anode of the APD. In this case, the semiconductor region of the first conductivity type is the P-type semiconductor region, and the semiconductor region of the second conductivity type is then N-type semiconductor region. Although the case where one node of the APD is set to a fixed potential is described below, potentials of both nodes may be varied.

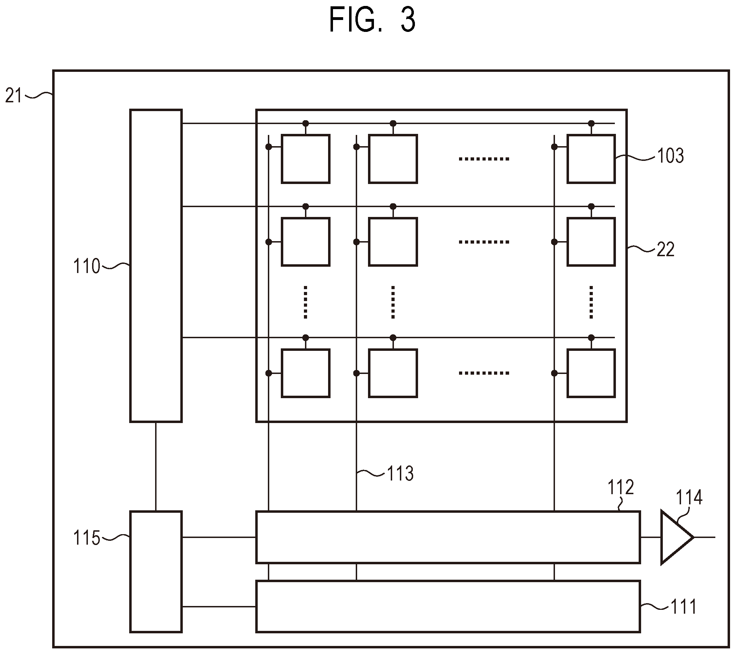

Fig. 3 is a schematic block diagram illustrating a configuration example of the circuit substrate 21. The circuit substrate 21 has the first circuit region 22 in which a plurality of pixel signal processing units 103 are arranged to form a plurality of rows and a plurality of columns.

The circuit substrate 21 includes a vertical scanning circuit 110, a horizontal scanning circuit 111, a reading circuit 112, a pixel output signal line 113, an output circuit 114, and a control signal generation unit 115. The plurality of photoelectric conversion units 102 illustrated in Fig. 2 and the plurality of pixel signal processing units 103 illustrated in Fig. 3 are electrically connected to each other via connection wirings provided for the respective pixels 101

The control signal generation unit 115 is a control circuit that generates control signals for driving the vertical scanning circuit 110, the horizontal scanning circuit 111, and the reading circuit 112 and supplies the control signals to these units. As a result, the control signal generation unit 115 controls the driving timings and the like of each unit.

The vertical scanning circuit 110 supplies control signals to each of the plurality of pixel signal processing units 103 based on the control signal supplied from the control signal generation unit 115. The vertical scanning circuit 110 supplies control signals for each row to the pixel signal processing unit 103 via a driving line provided for each row of the first circuit region 22. As will be described later, a plurality of driving lines may be provided for each row. A logic circuit such as a shift register or an address decoder can be used for the vertical scanning circuit 110. Thus, the vertical scanning circuit 110 selects a row to be output a signal from the pixel signal processing unit 103.

The signal output from the photoelectric conversion unit 102 of the pixel circuit 101 is processed by the pixel signal processing unit 103. The pixel signal processing unit 103 acquires and holds a digital signal based on pulses output from the APD included in the photoelectric conversion unit 102.

The horizontal scanning circuit 111 supplies control signals to the reading circuit 112 based on a control signal supplied from the control signal generation unit 115. The pixel signal processing unit 103 is connected to the reading circuit 112 via a pixel output signal line 113 provided for each column of the first circuit region 22. The pixel output signal line 113 in one column is shared by a plurality of pixel signal processing units 103 in the corresponding column. The pixel output signal line 113 includes a plurality of wirings, and has at least a function of outputting a digital signal from the pixel signal processing unit 103 to the reading circuit 112, and a function of supplying a control signal for selecting a column for outputting a signal to the pixel signal processing unit 103. The reading circuit 112 outputs a signal to a signal processing device or the like outside the photoelectric conversion device 100 via the output circuit 114 based on the control signal supplied from the control signal generation unit 115.

The function of the pixel signal processing unit 103 does not necessarily have to be provided one by one in all the pixels 101. For example, one pixel signal processing unit 103 may be shared by a plurality of pixels 101. In this case, the pixel signal processing unit 103 sequentially processes the signals output from the photoelectric conversion units 102, thereby providing the function of signal processing to each pixel 101.

As illustrated in Figs. 2 and 3, the first circuit region 22 having a plurality of pixel signal processing units 103 is arranged in a region overlapping the pixel region 12 in the plan view. In the plan view, the vertical scanning circuit 110, the horizontal scanning circuit 111, the reading circuit 112, the output circuit 114, and the control signal generation unit 115 are arranged so as to overlap a region between an edge of the sensor substrate 11 and an edge of the pixel region 12. In other words, the sensor substrate 11 includes the pixel region 12 and a non-pixel region arranged around the pixel region 12. In the circuit substrate 21, the second circuit region 23 having the vertical scanning circuit 110, the horizontal scanning circuit 111, the reading circuit 112, the output circuit 114, and the control signal generation unit 115 is arranged in a region overlapping with the non-pixel region in the plan view.

Note that the arrangement of the pixel output signal line 113, the arrangement of the reading circuit 112, and the arrangement of the output circuit 114 are not limited to those illustrated in Fig. 3. For example, the pixel output signal lines 113 may extend in the row direction, and may be shared by a plurality of pixel signal processing units 103 in corresponding rows. The reading circuit 112 may be provided so as to be connected to the pixel output signal line 113 of each row.

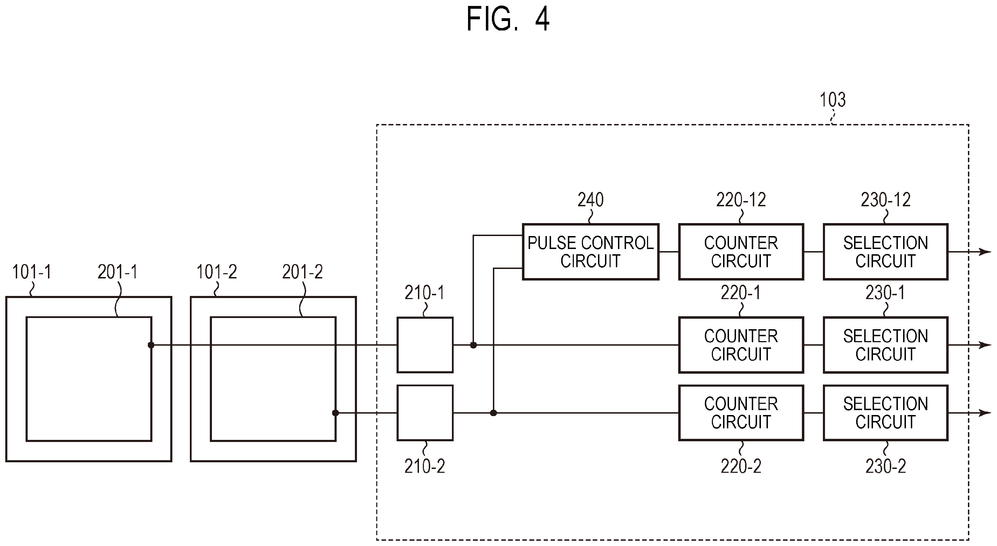

Fig. 4 is a block diagram illustrating a configuration example of a pixel circuit according to the present embodiment. Fig. 4 illustrates a schematic configuration of a pixel circuit including two pixels 101-1 and 101-2 and the pixel signal processing unit 103. The pixel 101-1 includes an APD 201-1, and the pixel 101-2 includes an APD 201-2. The pixel signal processing unit 103 includes waveform shaping circuits 210-1 and 210-2, counter circuits 220-1, 220-2, and 220-12, selection circuits 230-1, 230-2, and 230-12, and a pulse control circuit 240. A plurality of microlenses may be arranged so as to respectively correspond to the plurality of APDs. The microlens is arranged so as to cover an incident surface side of a corresponding APD, and guides incident light to the corresponding APD.

The waveform shaping circuits 210-1 and 210-2 respectively shape the signals output from the APDs 201-1 and 201-2 according to the incident photons to generate pulsed signals. The pulsed signal output from the waveform shaping circuit 210-1 is input to the counter circuit 220-1 and the pulse control circuit 240. The pulsed signal output from the waveform shaping circuit 210-2 is input to the counter circuit 220-2 and the pulse control circuit 240. The pulse control circuit 240 outputs a pulsed signal obtained by combining the pulsed signal output from the waveform shaping circuit 210-1 and the pulsed signal output from the waveform shaping circuit 210-2 to the counter circuit 220-12.

Each of the counter circuits 220-1, 220-2, and 220-12 counts the number of pulses included in the pulsed signal that is input to generate a count value, and holds the count value. A count value based on an incident photon to the APD 201-1 is held in the counter circuit 220-1, and a count value based on an incident photon to the APD 201-2 is held in the counter circuit 220-2. A count value corresponding to an added value of the count value based on the incident photon to the APD 201-1 and the count value based on the incident photon to the APD 201-2 is held in the counter circuit 220-12. The selection circuits 230-1, 230-2, and 230-12 respectively output the count values held in the counter circuit 220-1, 220-2, and 220-12 to the pixel output signal line 113 when selected in accordance with a selection signal.

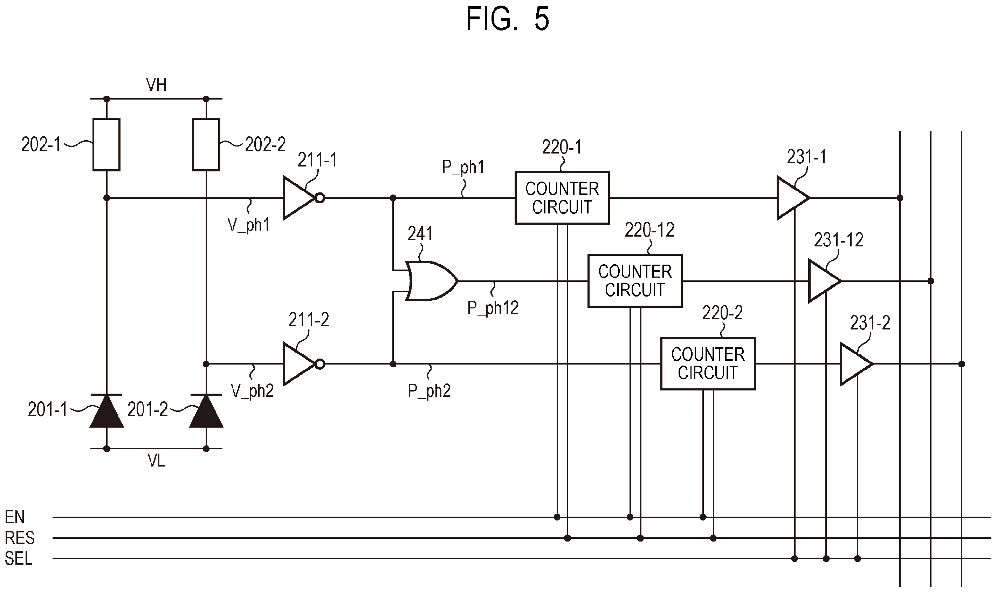

Fig. 5 is a circuit diagram illustrating a configuration example of the pixel circuit according to the present embodiment. Fig. 5 illustrates an example of a specific circuit corresponding to the block diagram illustrated in Fig. 4. The pixel circuit includes the APDs 201-1 and 201-2, quenching elements 202-1 and 202-2, inverters 211-1 and 211-2, the counter circuits 220-1, 220-2, and 220-12, buffers 231-1, 231-2, and 231-12, and an OR circuit 241.

In the circuit example of Fig. 5, the waveform shaping circuits 210-1 and 210-2 are constituted by the inverters 211-1 and 211-2, respectively. The selection circuits 230-1, 230-2, and 230-12 are constituted by the buffers 231-1, 231-2, and 231-12, respectively. The pulse control circuit 240 is constituted by the OR circuit 241.

Each of the APDs 201-1 and 201-2 (first avalanche photodiode and second avalanche photodiode) generates a charge according to incident light by photoelectric conversion. A voltage VL is supplied to anodes of the APDs 201-1 and 201-2. A cathode of the APD 201-1 is connected to a first terminal of the quenching element 202-1 and an input terminal of the inverter 211-1. A cathode of the APD 201-2 is connected to a first terminal of the quenching element 202-2 and an input terminal of the inverter 211-2. A voltage VH higher than the voltage VL is supplied to second terminals of the quenching elements 202-1 and 202-2. As a result, the anodes and the cathodes of the APDs 201-1 and 201-2 are supplied with reverse bias voltages so that the APDs 201-1 and 201-2 perform the avalanche multiplication operation. When a charge is generated by incident light in the APDs 201-1 and 201-2 to which the reverse bias voltage is supplied, the charge causes avalanche multiplication, and an avalanche current is generated.

Note that the operation modes when the reverse bias voltage is supplied to the APDs 201-1 and 201-2 include a Geiger mode and a linear mode. The Geiger mode is a mode in which a potential difference between the anode and the cathode is larger than a breakdown voltage, and the linear mode is a mode in which a potential difference between the anode and the cathode is close to or smaller than the breakdown voltage.

The APD operated in the Geiger mode is referred to as a single photon avalanche diode (SPAD). In this case, for example, the voltage VL (first voltage) is -30 V, and the voltage VH (second voltage) is 1 V. The APDs 201-1 and 201-2 may operate in the linear mode or the Geiger mode. In the case of the SPAD, since the potential difference becomes large and the effect of avalanche multiplication becomes remarkable as compared with the APD of the linear mode, the SPAD may be used.

Each of the quenching elements 202-1 and 202-2 functions as a load circuit (quenching circuit) at the time of signal multiplication by avalanche multiplication. The quenching elements 202-1 and 202-2 suppress the voltages supplied to the APDs 201-1 and 201-2, respectively, to suppress avalanche multiplication (quenching operation). In addition, the quenching elements 202-1 and 202-2 return the voltage supplied to the APDs 201-1 and 201-2 to the voltage VH by flowing a current corresponding to the voltage drop due to the quenching operation (recharge operation). In the present embodiment, the quenching elements 202-1 and 202-2 are assumed to be resistive elements, but the quenching elements 202-1 and 202-2 may be transistors.

The inverter 211-1 shapes a change in a cathode potential V_ph1 of the APD 201-1 at the time of photon detection and outputs a pulsed signal P_ph1 (first pulsed signal). The pulsed signal P_ph1 is input to a first input terminal of the OR circuit 241 and the counter circuit 220-1 (first counter). The inverter 211-2 shapes a change in a cathode potential V_ph2 of the APD 201-2 at the time of photon detection and outputs a pulsed signal P_ph2 (second pulsed signal). The pulsed signal P_ph2 is input to a second input terminal of the OR circuit 241 and the counter circuit 220-2 (second counter). The OR circuit 241 outputs a logical sum of the pulsed signal P_ph1 and the pulsed signal P_ph2 as a pulsed signal P_ph12 (combined pulsed signal) to the counter circuit 220-12 (third counter).

Fig. 5 illustrates an example in which each of the waveform shaping circuits 210-1 and 210-2 is constituted by one inverter. However, each of the waveform shaping circuits 210-1 and 210-2 may be a circuit in which a plurality of inverters are connected in series, or may be another circuit having a waveform shaping effect.

The counter circuits 220-1, 220-2, and 220-12 count the number of pulses included in the pulsed signals P_ph1, P_ph2, and P_ph12, respectively, and hold the count values. When a reset signal RES is supplied from the vertical scanning circuit 110 through the drive line, the counter circuits 220-1, 220-2, and 220-12 reset the count values that are held therein. An enable signal EN is input to the counter circuits 220-1, 220-2, and 220-12 from the vertical scanning circuit 110 via the drive line. The enable signal EN controls a period (exposure period) in which counting is performed in the counter circuits 220-1, 220-2, and 220-12.

The counter circuits 220-1, 220-2, and 220-12 are connected to input terminals of buffers 231-1, 231-2, and 231-12, respectively. A selection signal SEL for controlling whether to output the count values from the counter circuits 220-1, 220-2, and 220-12 is input to the buffers 231-1, 231-2, and 231-12 from the vertical scanning circuit 110 via the drive line. The buffers 231-1, 231-2, and 231-12 enabled according to the selection signal SEL output the count values held in the corresponding counter circuits 220-1, 220-2, and 220-12 to the corresponding signal lines of the pixel output signal line 113.

In Fig. 5, the enable signal EN and the reset signal RES are input to the counter circuits 220-1, 220-2, and 220-12 in common, and the selection signal SEL is input to the buffers 231-1, 231-2, and 231-12 in common, but the present embodiment is not limited thereto. For example, individual enable signals EN or individual reset signals RES may be input to the counter circuits 220-1, 220-2, and 220-12. In addition, for example, individual selection signals SEL may be input to the buffers 231-1, 231-2, and 231-12. In these cases, the number of drive lines may be appropriately increased in accordance with the number of types of input signals.

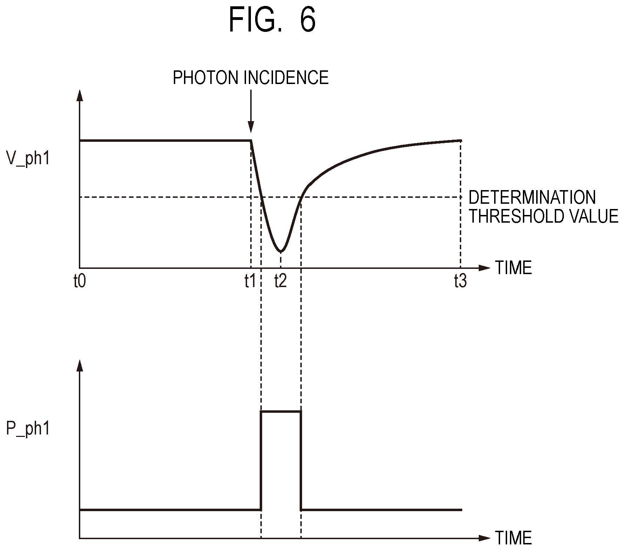

Fig. 6 is a diagram illustrating an operation of the APD 201-1 according to the present embodiment. Fig. 6 illustrates temporal changes in levels of the cathode potential V_ph1 and the pulsed signal P_ph1 of the APD 201-1 at the time of photon incidence. Since the operation of the APD 201-2 is the same as the operation of the APD 201-1, the description thereof will be omitted.

In a period from time t0 to time t1, a voltage of VH-VL is applied to the APD 201-1. When a photon is incident on the APD 201-1 at the time t1, avalanche multiplication occurs in the APD 201-1. As a result, an avalanche current flows through the quenching element 202-1, and the cathode potential V_ph1 drops. Thereafter, the amount of potential drop further increases, and the voltage applied to the APD 201-1 gradually decreases. Then, at time t2, the avalanche multiplication in the APD 201-1 is stopped. As a result, the cathode potential V_ph1 does not drop below a certain constant value. Thereafter, in a period from the time t2 to time t3, a current that compensates for the voltage drop flows from the node of the voltage VH to the cathode of the APD 201-1, and the cathode potential V_ph1 is settled to the original potential at the time t3.

In the above-described process, the potential of the pulsed signal P_ph1 output from the inverter 211-1 becomes the high level in a period in which the cathode potential V_ph1 is lower than a certain threshold value. In this manner, the waveform of the drop of the cathode potential V_ph1 caused by the incidence of the photon is shaped by the inverter 211-1, and is output as the pulsed signal P_ph1 from the inverter 211-1.

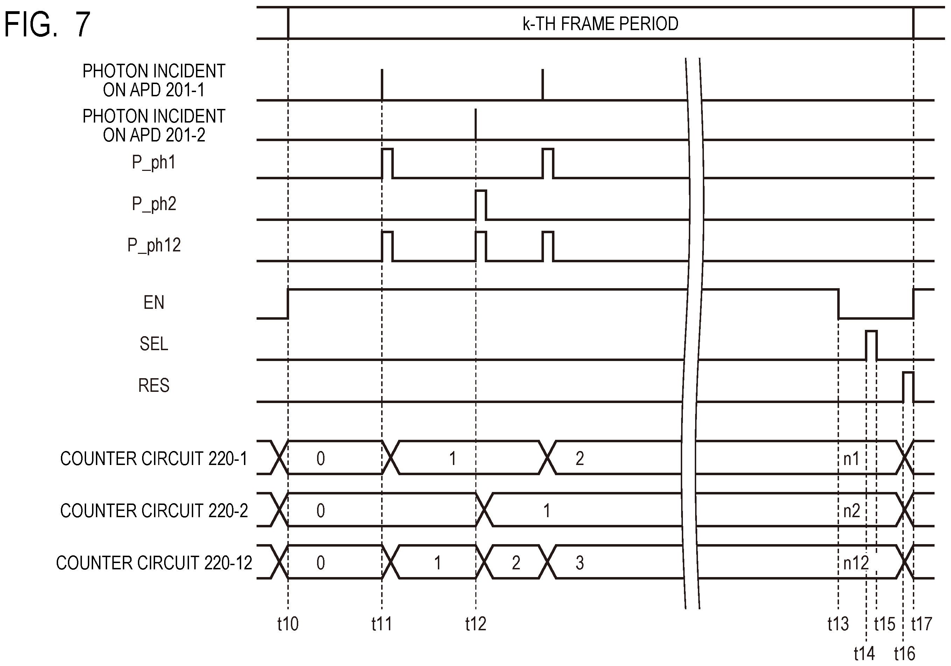

Fig. 7 is a timing chart illustrating an operation of the photoelectric conversion device 100 according to the present embodiment. Fig. 7 illustrates an operation in one frame period of the photoelectric conversion device 100. The one frame period is referred to as a k-th frame period. Fig. 7 illustrates temporal changes in the levels of the pulsed signals P_ph1, P_ph2, and P_ph12, the enable signal EN, the selection signal SEL, and the reset signal RES. Further, Fig. 7 illustrates the incident timings of photons to the APDs 201-1 and 201-2 and the temporal changes in the count values held in the counter circuits 220-1, 220-2, and 220-12.

At time t10, the enable signal EN changes from the low level to the high level, and the count operation in the counter circuits 220-1, 220-2, and 220-12 is enabled. Thus, the exposure operation in the k-th frame period starts.

When a photon is incident on the APD 201-1 at time t11, the pulsed signal P_ph1 becomes the high level, and one pulse is generated. The generated pulse is input to the counter circuit 220-1, and the count value of the counter circuit 220-1 changes from zero to one. At the same time, the generated pulse is also input to the OR circuit 241, the pulsed signal P_ph12 becomes the high level, and one pulse is generated. The generated pulse is input to the counter circuit 220-12, and the count value of the counter circuit 220-12 changes from zero to one.

When a photon is incident on the APD 201-2 at time t12, the pulsed signal P_ph2 becomes the high level, and one pulse is generated. The generated pulse is input to the counter circuit 220-2, and the count value of the counter circuit 220-2 changes from zero to one. At the same time, the generated pulse is also input to the OR circuit 241, the pulsed signal P_ph12 becomes the high level, and one pulse is generated. The generated pulse is input to the counter circuit 220-12, and the count value of the counter circuit 220-12 changes from one to two. After the time t12, the number of incident photons is counted in the same manner.

At time t13, the enable signal EN changes from the high level to the low level, and the count operation in the counter circuits 220-1, 220-2, and 220-12 is disabled. Thus, the exposure operation in the k-th frame period ends.

In a period from time t14 to time t15, the selection signal SEL becomes the high level. Thus, digital signals indicating count values n1, n2, and n12 respectively held in the counter circuits 220-1, 220-2, and 220-12 are simultaneously read out to the outside of the pixel.

In a period from time t16 to time t17, the reset signal RES becomes the high level. As a result, the count value held in each of the counter circuits 220-1, 220-2, and 220-12 is reset to zero. Then, at the time t17, the enable signal EN changes from the low level to the high level again, and the exposure operation in a (k+1)-th frame period starts.

As described above, the pixel circuit of the photoelectric conversion device 100 according to the present embodiment can output, in addition to the count value based on the incident photon to the APD 201-1 and the count value based on the incident photon to the APD 201-2, the count value corresponding to the added value of these count values. These count values can be used for image generation. The pixel circuit of the photoelectric conversion device 100 according to the present embodiment can collectively output a signal of each APD and a signal obtained by binning signals from two APDs. Although the binned signal has a lower spatial resolution than the signal of each APD, the binned signal has a high sensitivity.

When binning is performed in the configuration in which only the count value based on the incident photon to the APD 201-1 and the count value based on the incident photon to the APD 201-2 are output, arithmetic processing for binning may be necessary after the count values are read. On the other hand, in the present embodiment, since the binning is completed in the pixel circuit, the arithmetic processing for generating a binned signal can be omitted. Therefore, according to the present embodiment, the photoelectric conversion device 100 capable of speeding up signal processing is provided.

When the signal of each APD is unnecessary and it is desired to acquire only the binned signal, a reading operation of reading only the counter circuit 220-12 may be employed. In this case, the number of times of reading can be reduced, and the speed of the reading operation can be increased. In addition, when the binning is unnecessary and only the individual signals of each of the APDs are desired to be acquired, a reading operation of reading only the counter circuits 220-1 and 220-2 may be employed. Also in this case, the number of times of reading can be reduced, and the speed of the reading operation can be increased.

It is desirable that the number of bits of the counter circuit 220-12 is greater than either the number of bits of the counter circuit 220-1 or the number of bits of the counter circuit 220-2. Normally, the count value held by the counter circuit 220-12 is greater than the count values held by the counter circuits 220-1 and 220-2. Therefore, by making the number of bits of the counter circuit 220-12 greater than the number of bits of the counter circuits 220-1 and 220-2, it is possible to optimize the range of count values that can be held.

### First Modification of First Embodiment

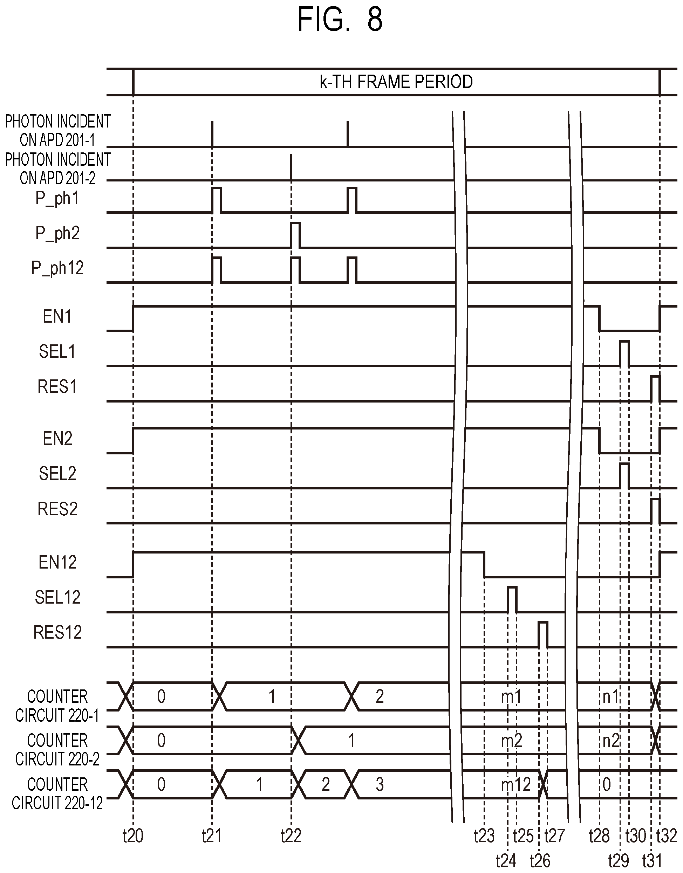

Fig. 8 is a timing chart illustrating an operation of the photoelectric conversion device 100 according to a first modification of the present embodiment. In the present modification, the exposure period in the counter circuits 220-1 and 220-2 and the exposure period in the counter circuit 220-12 are different from each other. In the present modification, individual enable signals EN1, EN2, and EN12 and individual reset signals RES1, RES2, and RES12 are input to the counter circuits 220-1, 220-2, and 220-12, respectively. In addition, individual selection signals SEL1, SEL2, and SEL12 are input to the buffers 231-1, 231-2, and 231-12, respectively.

At time t20, the enable signals EN1, EN2, and EN12 change from the low level to the high level, and the count operation in the counter circuits 220-1, 220-2, and 220-12 is enabled. Thus, the exposure operation in the k-th frame period starts. Since the operation at time t21 and time t22 is the same as the operation at the time t11 and the time t12 in Fig. 7, the description thereof will be omitted.

At time t23, the enable signal EN12 changes from the high level to the low level, and the count operation in the counter circuit 220-12 is disabled. As a result, the exposure operation ends in the counter circuit 220-12, but the exposure operation continues in the counter circuits 220-1 and 220-2.

In a period from time t24 to time t25, the selection signal SEL12 becomes the high level. As a result, the digital signal indicating the count value m12 held in the counter circuit 220-12 is read out to the outside of the pixel.

In a period from time t26 to time t27, the reset signal RES12 is becomes the high level. As a result, the count value held in the counter circuit 220-12 is reset to zero.

At time t28, the enable signals EN1 and EN2 change from the high level to the low level, and the count operation in the counter circuits 220-1 and 220-2 are disabled. As a result, the exposure operation in the counter circuits 220-1 220-2 is also ended.

In a period from time t29 to time t30, the selection signals SEL1 and SEL2 become the high level. As a result, the digital signals indicating the count values n1 and n2 respectively held in the counter circuits 220-1 and 220-2 are simultaneously read out to the outside of the pixel.

In a period from time t31 to time t32, the reset signals RES1 and RES2 become the high level. As a result, the count value held in each of the counter circuits 220-1 and 220-2 is reset to zero. Then, at the time t32, the enable signals EN1, EN2, and EN12 change from the low level to the high level again, and the exposure operation in a (k+1)-th frame period starts.

Similarly, in the present modification, the photoelectric conversion device 100 capable of speeding up signal processing is provided. In addition, in the present modification, the signal of each APD and the binned signal can be read out asynchronously, and the exposure times of those signals can be made different. In the present modification, the count value of the counter circuit 220-12 holding the binned signal is read out earlier than the count values of the counter circuits 220-1 and 220-2. Accordingly, it is possible to obtain the binned signal at an early stage by shortening the exposure time of the binned signal while securing a sufficiently long exposure time of the signal of each APD. Examples of applications in which it is necessary to acquire the binned signal at an early stage include an image for determining a situation in autonomous driving.

### Second Modification of First Embodiment

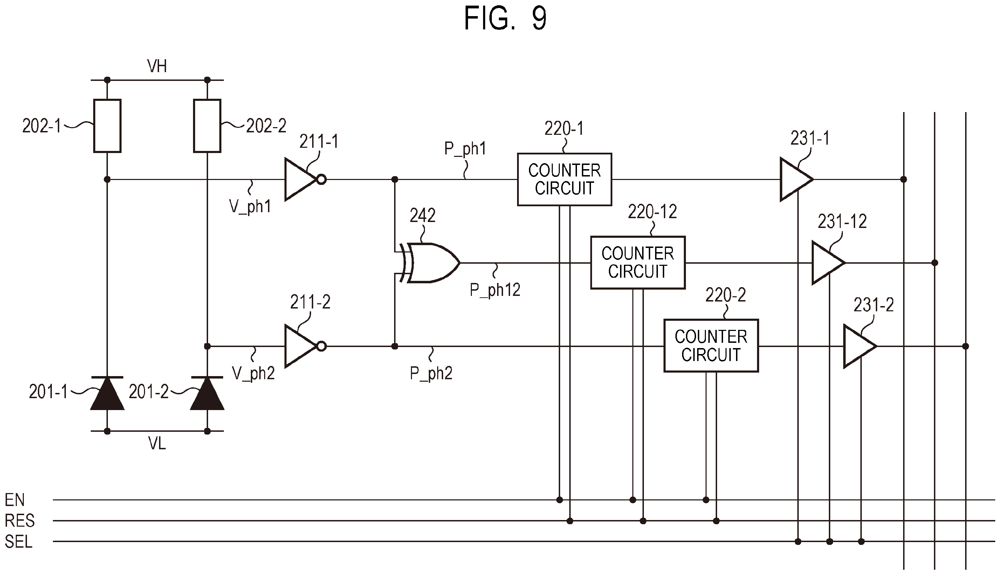

Fig. 9 is a circuit diagram illustrating a configuration example of a pixel circuit according to a second modification of the present embodiment. Fig. 9 is different from Fig. 5 in that an XOR circuit 242 is arranged instead of the OR circuit 241. The XOR circuit 242 outputs an exclusive OR of the pulsed signal P_ph1 and the pulsed signal P_ph2 to the counter circuit 220-12 as the pulsed signal P_ph12.

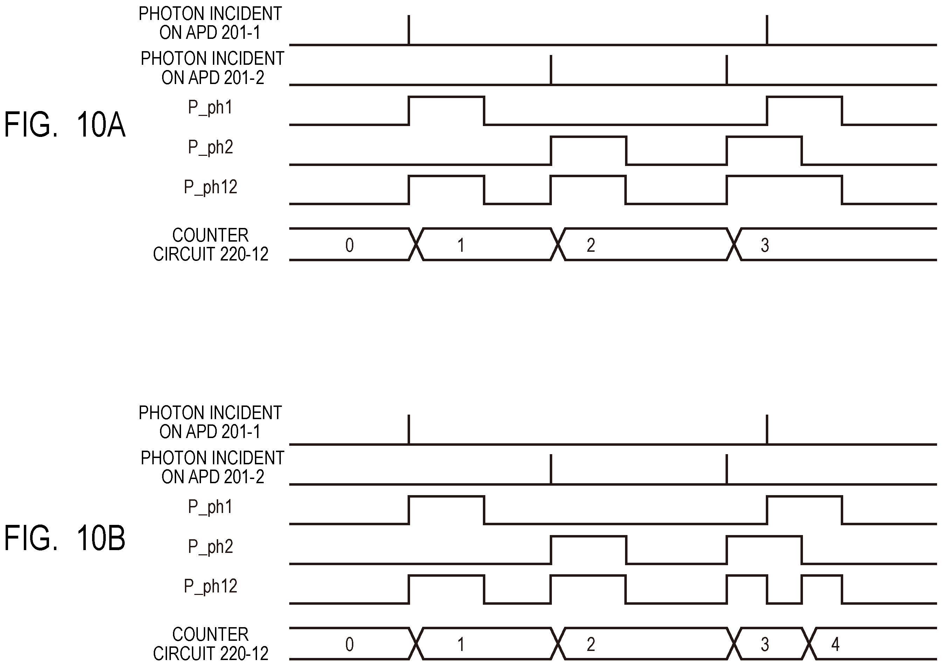

Figs. 10A and 10B are timing charts illustrating effects of the second modification of the first embodiment. Fig. 10A is a timing chart when the OR circuit 241 is arranged, and Fig. 10B is a timing chart when the XOR circuit 242 is arranged. Figs. 10A and 10B illustrate incident timings of photons to the APDs 201-1 and 201-2, temporal changes in the pulsed signals P_ph1, P_ph2, and P_ph12, and temporal changes in the count value held in the counter circuit 220-12.

In the example illustrated in Fig. 10A, two photons are incident on the APD 201-1 and two photons are incident on the APD 201-2. However, at the time of the second photon incidence on the APDs 201-1 and 201-2, since the periods during which the pulsed signals P_ph1 and P_ph2 are at the high level overlap, the number of pulses of the pulsed signal P_ph12, which is the logical sum of the pulsed signals P_ph1 and P_ph2, is three. Therefore, the number of photons incident on the APDs 201-1 and 201-2 does not match the count value held in the counter circuit 220-12.

In the example illustrated in Fig. 10B, two photons are incident on the APD 201-1 and two photons are incident on the APD 201-2. In Fig. 10B, as in Fig. 10A, the periods during which the pulsed signals P_ph1 and P_ph2 are at the high level overlap at the time of the second photon incidence on the APDs 201-1 and 201-2. The number of pulses of the pulsed signal P_ph12 which is an exclusive OR thereof is four. Therefore, the number of photons incident on the APDs 201-1 and 201-2 matches the count value held in the counter circuit 220-12.

Similarly, in the present modification, the photoelectric conversion device 100 capable of speeding up signal processing is provided. Further, in the present modification, by using the XOR circuit 242, it is possible to generate the pulsed signal P_ph12 having an appropriate number of pulses even when the periods during which the pulsed signals P_ph1 and P_ph2 are at the high level overlap. Accordingly, it is possible to more accurately acquire the binned signal.

### Third Modification of First Embodiment

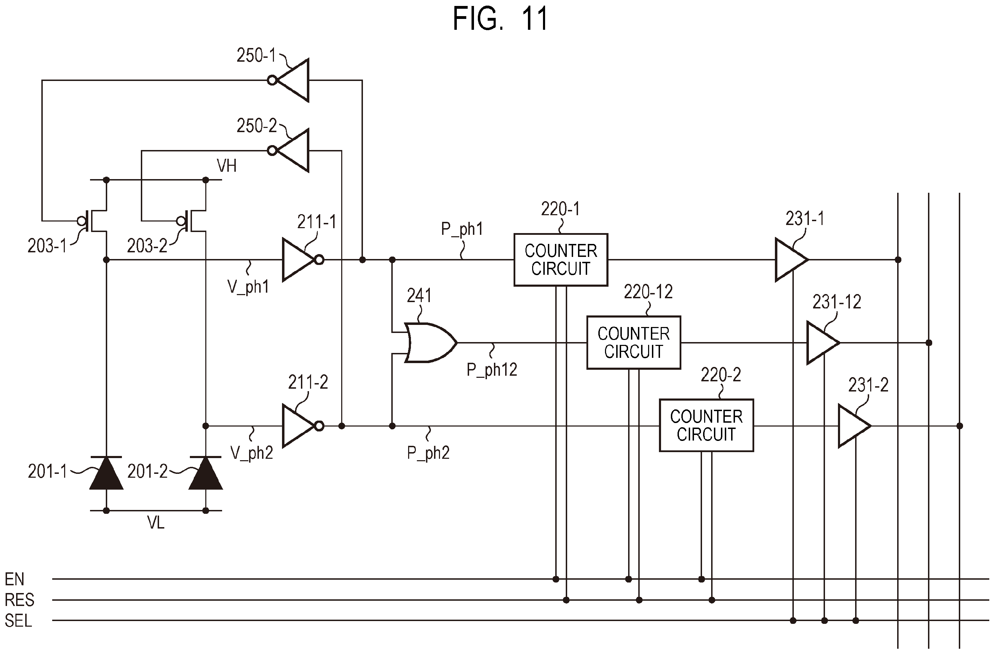

Fig. 11 is a circuit diagram illustrating a configuration example of a pixel circuit according to a third modification of the present embodiment. The pixel circuit of Fig. 5 is a passive recharge type in which passive elements are used as the quenching elements 202-1 and 202-2 and a recharge operation is performed passively. In contrast, in Fig. 11, transistors 203-1 and 203-2, which are P-type metal-oxide-semiconductor (MOS) transistors, are used as quenching elements. The transistors 203-1 and 203-2 function as switches for controlling the recharging operation in the APDs 201-1 and 201-2, respectively. In the present modification, inverters 250-1 and 250-2 are further added to the pixel circuit.

Drains of the transistors 203-1 and 203-2 are connected to the cathodes of the APDs 201-1 and 201-2, respectively. Sources of the transistors 203-1 and 203-2 are connected to a power supply potential line and supplied with the voltage VH. An input terminal of the inverter 250-1 is connected to the output terminal of the inverter 211-1, and the pulsed signal P_ph1 is input to the input terminal of the inverter 250-1. An input terminal of the inverter 250-2 is connected to the output terminal of the inverter 211-2, and the pulsed signal P_ph2 is input to the input terminal of the inverter 250-2. An output terminal of the inverter 250-1 is connected to a gate of the transistor 203-1. An output terminal of the inverter 250-2 is connected to a gate of the transistor 203-2.

When a photon is incident on the APD 201-1, the pulsed signal P_ph1 becomes the high level, and the gate potential of the transistor 203-1 becomes the low level. As a result, the transistor 203-1 is turned on, and a recharge operation is performed on the APD 201-1. Similarly, when a photon is incident on the APD 201-2, the APD 201-2 is also recharged. As described above, the pixel circuit of the present modification is an active recharge type in which a recharge operation is performed based on detection of a photon.

Similarly, in the present modification, the photoelectric conversion device 100 capable of speeding up signal processing is provided. Further, in the present modification, it is possible to reduce the influence of the pile-up which is likely to occur in the passive recharge type pixel circuit.

### Second Embodiment

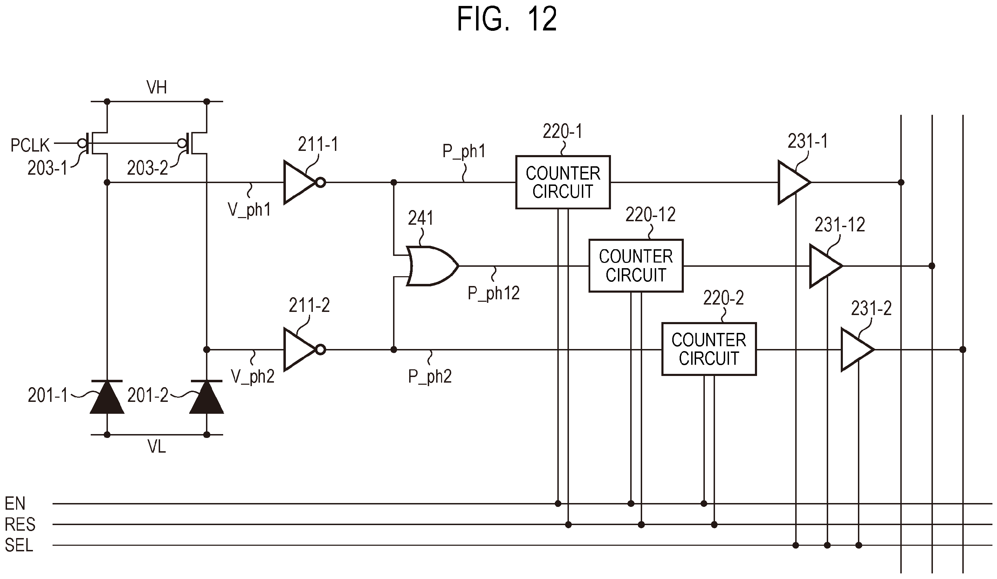

Fig. 12 is a circuit diagram illustrating a configuration example of the pixel circuit according to the present embodiment. In the present embodiment, the transistors 203-1 and 203-2 are used as quenching elements as in the third modification of the first embodiment. In the present embodiment, a control clock signal PCLK is input to the gates of the transistors 203-1 and 203-2 instead of the feedback control by the inverters 250-1 and 250-2. In the present embodiment, the recharge operation is periodically performed in accordance with the control clock signal PCLK. Such a driving method of the APDs 201-1 and 201-2 is referred to as clock-recharge driving.

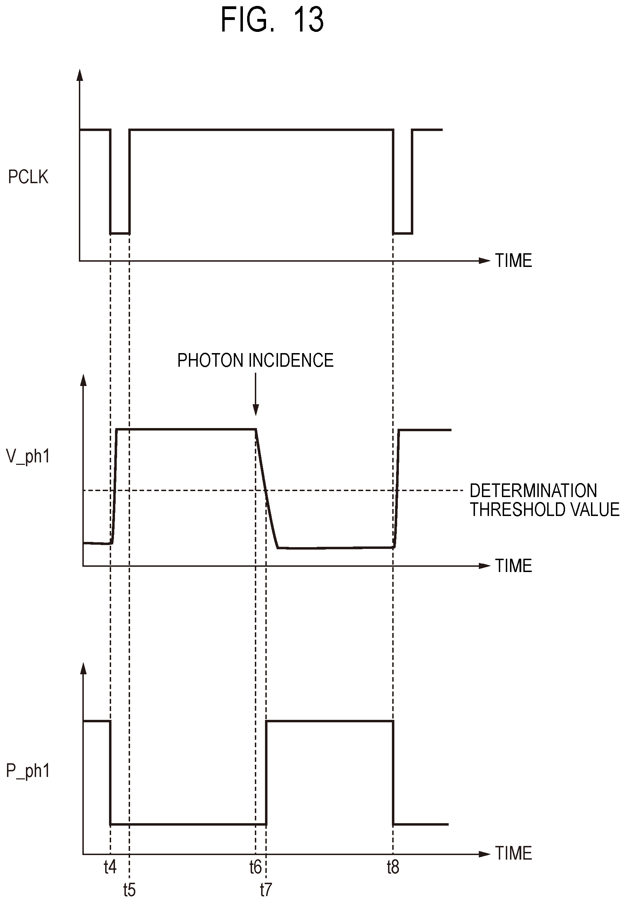

Fig. 13 is a diagram illustrating an operation of the APD 201-1 according to the present embodiment. Fig. 13 illustrates temporal changes in the level of the control clock signal PCLK, the cathode potential V_ph1 of the APD 201-1, and the level of the pulsed signal P_ph1. Since the operation of the APD 201-2 is the same as the operation of the APD 201-1, the description thereof will be omitted.

At time t4, the control clock signal PCLK changes from the high level to the low level. As a result, the transistor 203-1 is turned on, and a reverse bias voltage is applied to the APD 201-1. As a result, the cathode potential V_ph1 rises. When the cathode potential V_ph1 becomes higher than the threshold value, the pulsed signal P_ph1 changes from the high level to the low level. Thereafter, at time t5, the control clock signal PCLK changes from the low level to the high level, and the transistor 203-1 is turned off. The state of the APD 201-1 in a period from the time t4 to the time t5 may be referred to as a charge mode. The cycle of the charge mode is shorter than a length of one frame period, and an operation in which the charge mode is repeated a plurality of times within one frame period is performed. Therefore, the charge mode may be referred to as a recharge mode.

After the time t5, the state of the APD 201-1 becomes a standby mode waiting for an incidence of photon. When a photon is incident on the APD 201-1 at time t6, the cathode potential V_ph1 drops.

When the cathode potential V_ph1 becomes lower than the threshold value at time t7, the pulsed signal P_ph1 changes from the low level to the high level. Thereafter, at time t8, the control clock signal PCLK changes from the high level to the low level again. As a result, the standby mode ends, and the operation in the charge mode similar to the period from the time t4 to the time t5 is performed again. After the time t8, the same operation may be repeated.

In the clock-recharge driving as described above, even when a large number of photons are incident on the APD 201-1 within the period of the standby mode, at least one count value is added for each standby mode. Therefore, also in the present embodiment, the influence of the pile-up can be reduced.

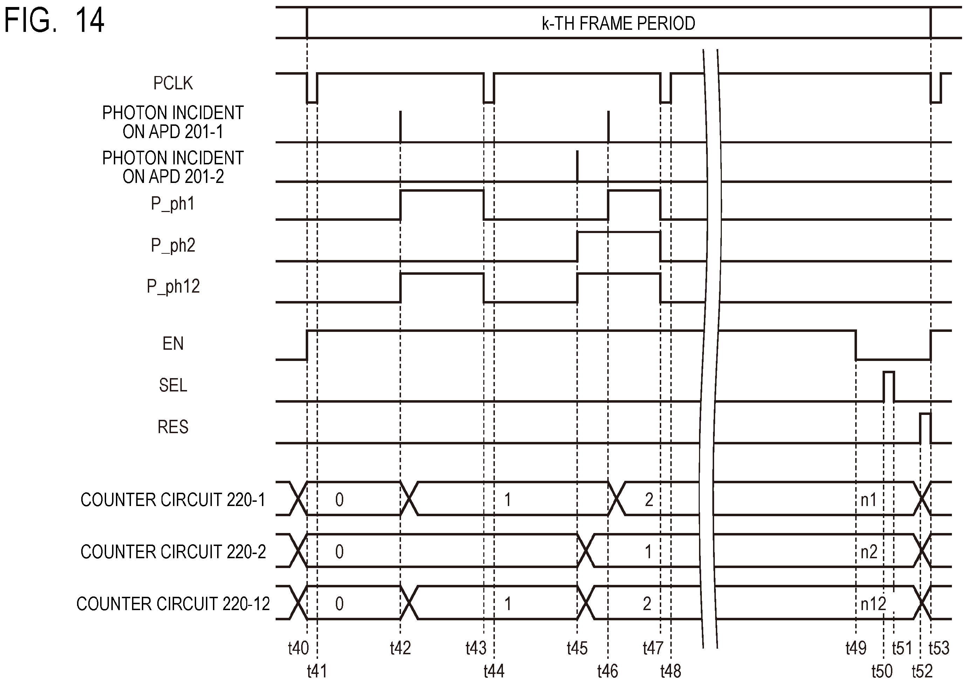

Fig. 14 is a timing chart illustrating an operation of the photoelectric conversion device 100 according to the present embodiment. Fig. 14 illustrates an operation in one frame period of the photoelectric conversion device 100. The one frame period is referred to as a k-th frame period. Fig. 14 further illustrates the control clock signal PCLK in addition to the signals illustrated in Fig. 7.

At time t40, the enable signal EN changes from the low level to the high level, and the count operation in the counter circuits 220-1, 220-2, and 220-12 is enabled. Thus, the exposure operation in the k-th frame period starts. In a period from the time t40 to time t41, the control clock signal PCLK becomes the low level, and the transistors 203-1 and 203-2 are turned on. As a result, the recharge operation is performed on the APDs 201-1 and 201-2.

When a photon is incident on the APD 201-1 at time t42, the pulsed signal P_ph1 becomes the high level, and the count value of the counter circuit 220-1 changes from zero to one due to the change in the signal level. At the same time, the pulsed signal P_ph12 also becomes the high level, and the count value of the counter circuit 220-12 changes from zero to one due to the change in the signal level.

In a period from time t43 to time t44, the control clock signal PCLK becomes the low level again, and the transistors 203-1 and 203-2 are turned on. As a result, the recharge operation is performed on the APDs 201-1 and 201-2.

When a photon is incident on the APD 201-2 at time t45, the pulsed signal P_ph2 becomes the high level, and the count value of the counter circuit 220-2 changes from zero to one due to the change in the signal level. At the same time, the pulsed signal P_ph12 also becomes the high level, and the count value of the counter circuit 220-12 changes from one to two due to the change in the signal level.

When a photon is incident on the APD 201-1 at time t46, the pulsed signal P_ph1 becomes the high level, and the count value of the counter circuit 220-1 changes from one to two due to the change in the signal level. However, since the pulsed signal P_ph12 is already at the high level, the count value of the counter circuit 220-12 does not change.

In a period from time t47 to time t48, the control clock signal PCLK becomes the low level again, and the transistors 203-1 and 203-2 are turned on. As a result, the recharge operation is performed on the APDs 201-1 and 201-2. In this way, photon detection and recharging are repeated.

At time t49, the enable signal EN changes from the high level to the low level, and the count operation in the counter circuits 220-1, 220-2, and 220-12 is disabled. Thus, the exposure operation in the k-th frame period ends.

In a period from time t50 to time t51, the selection signal SEL becomes the high level. As a result, digital signals indicating count values n1, n2, and n12 respectively held in the counter circuits 220-1, 220-2, and 220-12 are read out to the outside of the pixel.

In a period from time t52 to time t53, the reset signal RES becomes the high level. As a result, the count value held in each of the counter circuits 220-1, 220-2, and 220-12 is reset to zero. Then, at the time t53, the enable signal EN changes from the low level to the high level again, and the exposure operation in a (k+1)-th frame period starts.

Also in the present embodiment, similarly to the first embodiment, the photoelectric conversion device 100 capable of speeding up signal processing is provided. Further, in the present embodiment, the influence of the pile-up can be reduced by applying the clock-recharge driving.

In a period from the time t44 to the time t47, two photons are incident on the APD 201-1 and the APD 201-2 in total. However, since the counter circuit 220-12 counts the logical sum of the pulsed signals P_ph1 and P_ph2, the increase amount of the count value of the counter circuit 220-12 is not two but one. In this way, although some photons are not counted, in the case of clock-recharge driving, it is desirable to use a counting method in which the increase amount of the count value in such a case is set to one. This is because if the increase amount of the count value of the counter circuit 220-12 in the period from the time t44 to the time t47 is two, there is a possibility that image quality degradation occurs due to the nonlinear response of the count value with respect to the number of incident photons peculiar to the clock-recharge driving.

### Modification of Second Embodiment

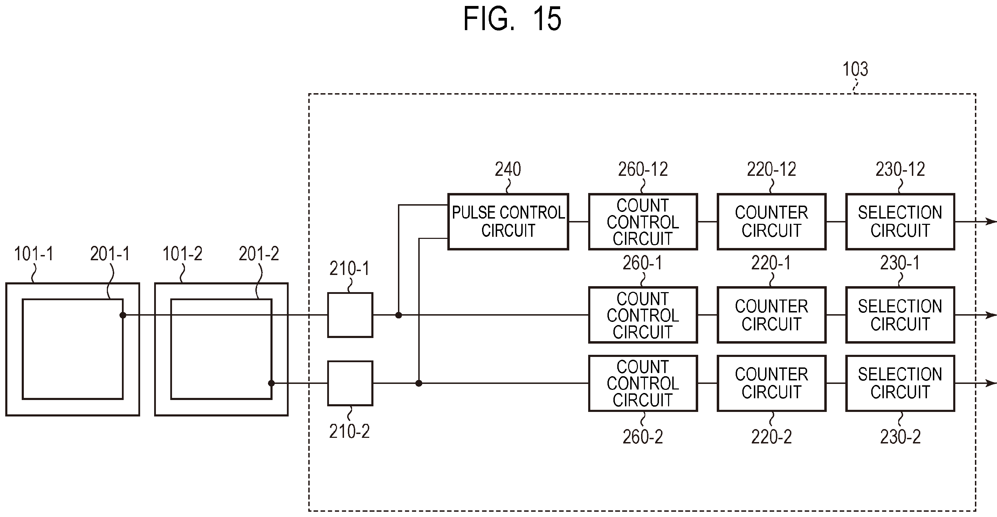

A configuration and a driving method of a pixel circuit capable of adding count values having different values according to incident timings of photons will be described as a modification of the second embodiment. Fig. 15 is a block diagram illustrating a configuration example of a pixel circuit according to a modification of the present embodiment. In addition to the configuration of the block diagram of Fig. 4, the pixel circuit of the present modification includes count control circuits 260-1, 260-2, and 260-12. The count control circuit 260-1 is arranged between the waveform shaping circuit 210-1 and the counter circuit 220-1, and the count control circuit 260-2 is arranged between the waveform shaping circuit 210-2 and the counter circuit 220-2. The count control circuit 260-12 is arranged between the pulse control circuit 240 and the counter circuit 220-12.

Each of the count control circuits 260-1, 260-2, and 260-12 sets an addition value of count values per pulse at the time of counting pulses. The addition value is a value that can vary according to time, and may be set to a value other than one. The addition value may be, for example, an integer value that varies one by one, such as one, two, and three, or an integer value that varies at unequal intervals, such as four, eight, and sixteen, depending on time. In addition, the addition value may include zero. In this case, zero means that the count value is not added.

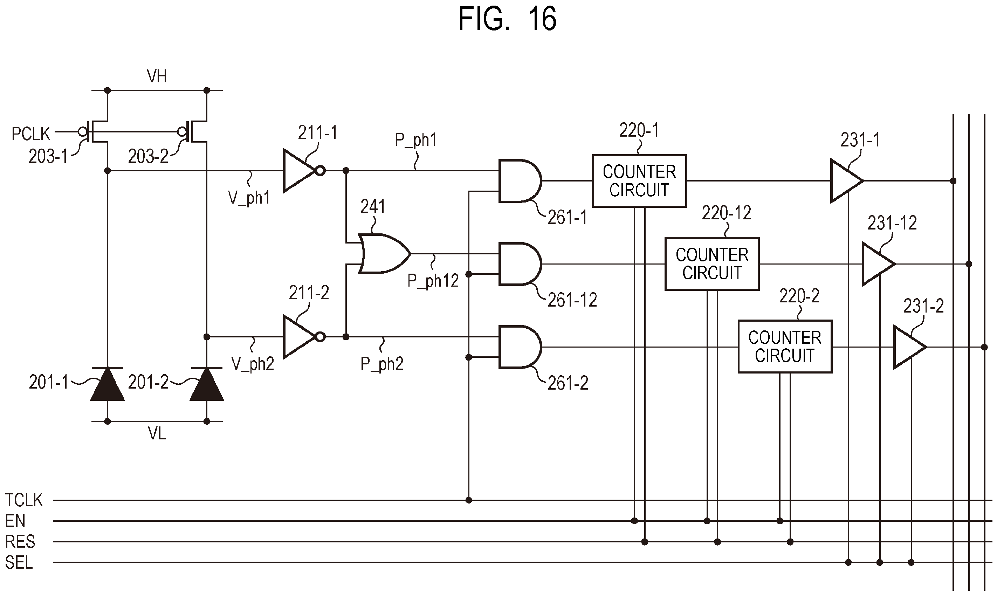

Fig. 16 is a circuit diagram illustrating a configuration example of a pixel circuit according to the modification of the present embodiment. Fig. 16 illustrates an example of a specific circuit corresponding to the block diagram illustrated in Fig. 15. In addition to the configuration of the circuit diagram of Fig. 12, the pixel circuit of the present modification includes AND circuits 261-1, 261-2, and 261-12. A first input terminal of the AND circuit 261-1 is connected to the output terminal of the inverter 211-1, and a first input terminal of the AND circuit 261-2 is connected to the output terminal of the inverter 211-2. A first input terminal of the AND circuit 261-12 is connected to the output terminal of the OR circuit 241. A pulsed signal TCLK is input to a second input terminal of each of the AND circuits 261-1, 261-2, and 261-12. Output terminals of the AND circuits 261-1, 261-2, and 261-12 are connected to the counter circuits 220-1, 220-2, and 220-12, respectively.

Therefore, the AND circuit 261-1 outputs a logical product of the pulsed signal P_ph1 and the pulsed signal TCLK to the counter circuit 220-1. The AND circuit 261-2 outputs a logical product of the pulsed signal P_ph2 and the pulsed signal TCLK to the counter circuit 220-2. The AND circuit 261-12 outputs a logical product of the pulsed signal P_ph12 and the pulsed signal TCLK to the counter circuit 220-12.

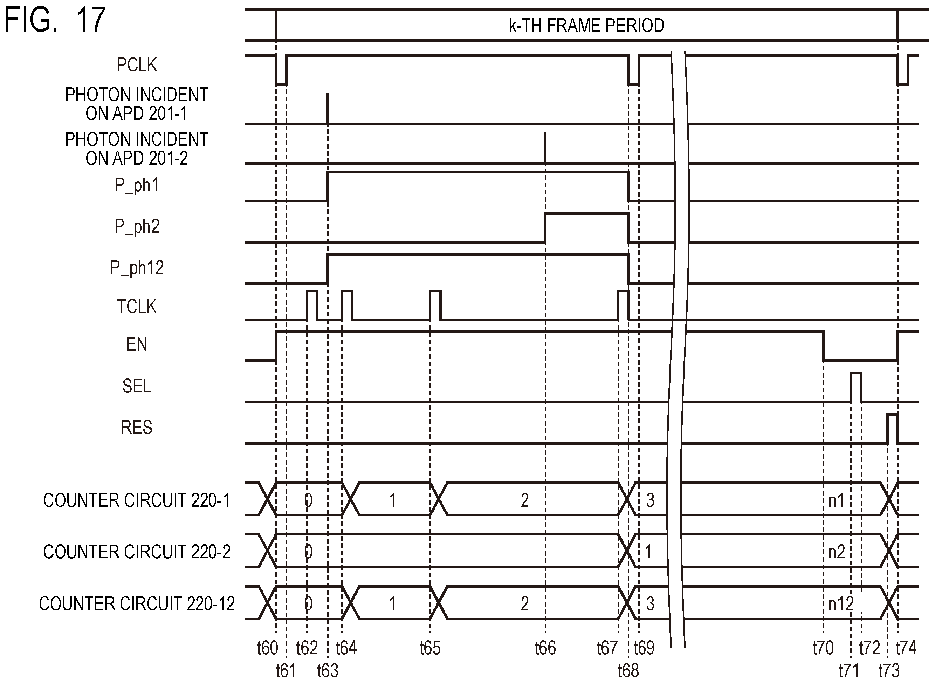

Fig. 17 is a timing chart illustrating an operation of the photoelectric conversion device 100 according to the modification of the present embodiment. Fig. 17 illustrates an operation in one frame period of the photoelectric conversion device 100. The one frame period is referred to as a k-th frame period. Fig. 17 further illustrates the pulsed signal TCLK in addition to the signals illustrated in Fig. 14.

At time t60, the enable signal EN changes from the low level to the high level, and the count operation in the counter circuits 220-1, 220-2, and 220-12 is enabled. Thus, the exposure operation in the k-th frame period starts. In a period from the time t60 to time t61, the control clock signal PCLK becomes the low level, and the transistors 203-1 and 203-2 are turned on. As a result, the recharge operation is performed on the APDs 201-1 and 201-2.

At time t62, the pulsed signal TCLK becomes the high level. However, at the time t62, since all of the pulsed signals P_ph1, P_ph2, and P_ph12 are at the low level, the outputs of the AND circuits 261-1, 261-2, and 261-12 remain at the low level. Therefore, the count values of the counter circuits 220-1, 220-2, and 220-12 do not change.

When a photon is incident on the APD 201-1 at time t63, the pulsed signal P_ph1 becomes the high level. At the same time, the pulsed signal P_ph12 also becomes the high level.

At time t64, the pulsed signal TCLK becomes the high level. At the time t64, the pulsed signals P_ph1 and P_ph12 are at the high level, and the pulsed signal P_ph2 is at the low level. Therefore, the outputs of the AND circuits 261-1 and 261-12 are at the high level, and the output of the AND circuit 261-2 remains at the low level. As a result, the count values of the counter circuits 220-1 and 220-12 change from zero to one, and the count value of the counter circuit 220-2 does not change.

At time t65, the pulsed signal TCLK becomes the high level. As a result, the count values of the counter circuits 220-1 and 220-12 change from one to two, as at the time t64.

When a photon is incident on the APD 201-2 at time t66, the pulsed signal P_ph2 becomes the high level. Since the pulsed signal P_ph12 is already at the high level, the pulsed signal P_ph12 does not change.

At time t67, the pulsed signal TCLK becomes the high level. At the time t67, the pulsed signals P_ph1, P_ph2, and P_ph12 are all at the high level. Therefore, the outputs of the AND circuits 261-1, 261-2, and 261-12 are all at the high level. As a result, the count values of the counter circuits 220-1 and 220-12 change from two to three, and the count value of the counter circuit 220-2 changes from zero to one. Since the operation after time t68 is the same as that after the time t48 in Fig. 14, the description thereof will be omitted.

As described above, in the present modification, after a photon is detected in each of the APDs 201-1 and 201-2, the count value is increased by one every time the pulsed signal TCLK becomes the high level. As a result, in the example of Fig. 17, the count values of the counter circuits 220-1 and 220-12 increase by three and the count value of the counter circuit 220-2 increases by one, by one photon detection. This difference in count values reflects the incident timings of photons within one frame period, and the earlier the incident timing, the larger the amount of increase in count value.

Similarly, in the present modification, the photoelectric conversion device 100 capable of speeding up signal processing is provided. Further, in the present modification, different values are added to the count values according to the timings at which the photons are incident on the APDs 201-1 and 201-2 after the recharge operation. Thus, the resulting count value includes time information about the incident timing of the photon. In the clock-recharge driving, since this time information correlates with the amount of light, it is possible to acquire information on the amount of light up to a range of a higher amount of light by performing arithmetic processing of estimating the amount of light from the acquired count value. Therefore, it is possible to perform imaging in which the dynamic range is expanded and a bright object is less likely to be overexposed.

### Third Embodiment

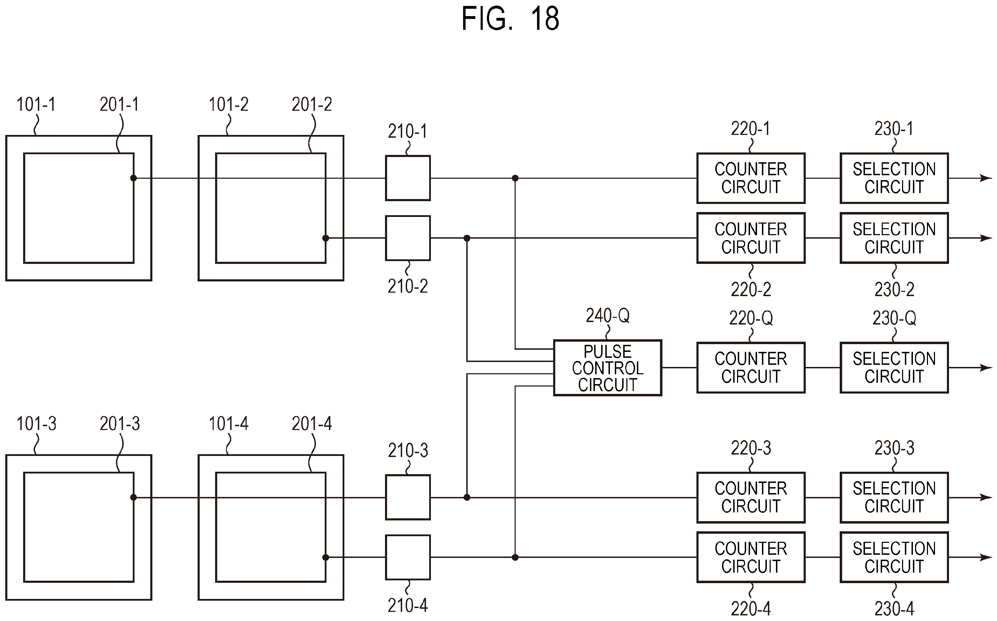

In the present embodiment, a configuration capable of performing binning of four pixels will be described. Fig. 18 is a block diagram illustrating a configuration example of a pixel circuit according to the present embodiment. Fig. 18 schematically illustrates an arrangement of counter circuits and the like with respect to four pixels 101-1, 101-2, 101-3, and 101-4. The pixel 101-1 includes an APD 201-1 (first avalanche photodiode), and the pixel 101-2 includes an APD 201-2 (second avalanche photodiode). The pixel 101-3 includes an APD 201-3 (seventh avalanche photodiode), and the pixel 101-4 includes an APD 201-4 (eighth avalanche photodiode).

The pixel circuit of Fig. 18 includes waveform shaping circuits 210-1 to 210-4 and a pulse control circuit 240-Q. Further, the pixel circuit of Fig. 18 includes counter circuits 220-1, 220-2, 220-3, 220-4, and 220-Q and selection circuits 230-1, 230-2, 230-3, 230-4, and 230-Q. Since the function of each block is the same as that of the first embodiment or the second embodiment, the description thereof will be omitted.

The signals output from the APDs 201-1 to 201-4 are shaped by the waveform shaping circuits 210-1 to 210-4, respectively. The pulsed signal (first pulsed signal) output from the waveform shaping circuit 210-1 is input to the counter circuit 220-1 and the pulse control circuit 240-Q. The pulsed signal (second pulsed signal) output from the waveform shaping circuit 210-2 is input to the counter circuit 220-2 and the pulse control circuit 240-Q. The pulsed signal (seventh pulsed signal) output from the waveform shaping circuit 210-3 is input to the counter circuit 220-3 and the pulse control circuit 240-Q. The pulsed signal (eighth pulsed signal) output from the waveform shaping circuit 210-4 is input to the counter circuit 220-4 and the pulse control circuit 240-Q. The pulse control circuit 240-Q may be, for example, an OR circuit having four input terminals or an XOR circuit having four input terminals.

The pulsed signal output from the pulse control circuit 240-Q is input to the counter circuit 220-Q. The selection circuits 230-1, 230-2, 230-3, 230-4, and 230-Q respectively output the count values held in the counter circuits 220-1, 220-2, 220-3, 220-4, and 220-Q to the pixel output signal line 113.

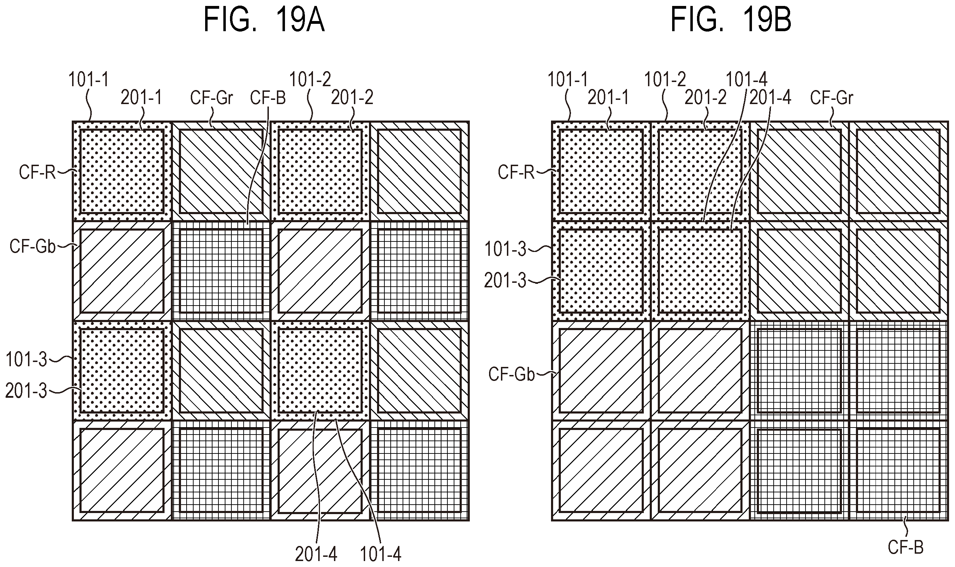

Figs. 19A and 19B are arrangement diagrams of the pixels 101 according to the present embodiment. In Figs. 19A and 19B, four rows and four columns of pixels 101 are extracted and illustrated from the plurality of pixels 101 arranged to form a plurality of rows and a plurality of columns. Each of the plurality of pixels 101 includes one APD 201.

In Fig. 19A, on each of the plurality of pixels 101, a color filter that transmits red, green, or blue light is arranged in a Bayer arrangement. That is, a red color filter CF-R is arranged on the upper left pixel 101 in the unit block of two rows and two columns, and a green color filter CF-Gr is arranged on the upper right pixel 101 in the unit block. Further, a green color filter CF-Gb is arranged on the lower left pixel 101 in the unit block of two rows and two columns, and a blue color filter CF-B is arranged on the lower right pixel 101 in the unit block. Accordingly, a signal including color information can be acquired, and a color image can be captured.

Here, the four pixels 101-1, 101-2, 101-3, and 101-4 to be binned, illustrated in Fig. 18, may be provided with color filters of the same color. This allows the signals to be binned for each color.

In Fig. 19B, on each of the plurality of pixels 101, a color filter that transmits red, green, or blue light is arranged in a quad Bayer arrangement. That is, the red color filter CF-R is arranged on the upper left four pixels 101 in the unit block of four rows and fur columns, and the green color filter CF-Gr is arranged on the upper right four pixels 101 in the unit block. Further, the green color filter CF-Gb is arranged on the lower left four pixels 101 in the unit block of four rows and four columns, and the blue color filter CF-B is arranged on the lower right four pixels 101 in the unit block. Accordingly, a signal including color information can be acquired, and a color image can be captured.

Similarly in the example of the quad Bayer arrangement, the four pixels 101-1, 101-2, 101-3, and 101-4 illustrated in Fig. 18 may be provided with color filters of the same color. This allows the signals to be binned for each color. Further, in the quad Bayer arrangement of Fig. 19B, since the pixels of the same color are adjacent to each other, the wiring lengths between the waveform shaping circuits 210-1 to 210-4 and the pulse control circuit 240-Q can be reduced as compared with the case of the Bayer arrangement of Fig. 19A. This facilitates the layout of the wiring.

Also in the present embodiment, similarly to the first embodiment, the photoelectric conversion device 100 capable of speeding up signal processing is provided. In addition, in the present embodiment, binning of four pixels can be performed. Further, in the present embodiment, as compared with a configuration in which binning of two pixels is performed as in the first embodiment and the second embodiment, the number of elements constituting the pulse control circuit, the counter circuit, and the selection circuit can be reduced, and the circuit scale can be reduced.

### Fourth Embodiment

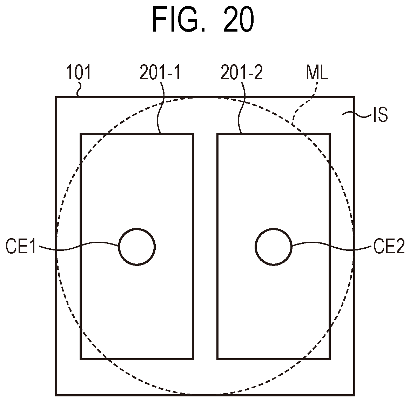

In the present embodiment, a pixel configuration capable of acquiring phase difference detection signals will be described. Fig. 20 is a schematic plan view of the pixel 101 according to the present embodiment. The pixel 101 includes APDs 201-1 and 201-2 and a microlens ML. That is, a plurality of microlenses ML are arranged so as to respectively correspond to the plurality of pixels 101, and one microlens ML is shared by the APDs 201-1 and 201-2. The microlens ML is arranged so as to cover the incident surface sides of the APDs 201-1 and 201-2, and guides incident light to the APDs 201-1 and 201-2.

Cathode electrodes CE1 and CE2 are arranged on the APDs 201-1 and 201-2, respectively. The cathode electrodes CE1 and CE2 are electrically connected to the pixel signal processing unit 103. An isolation region IS is arranged in a substrate between the APD 201-1 and the APD 201-2. The isolation region IS electrically isolates the APD 201-1 from the APD 201-2. The isolation region MAY be formed of a diffusion layer or an insulator such as an oxide film.

Accordingly, the pixel 101 of the present embodiment can output an imaging signal and phase difference detection signals. By adding the output signals of the APDs 201-1 and 201-2, the imaging signal is obtained. The phase difference can be detected by comparing the output signals of the APDs 201-1 and 201-2. Such a focus detection technique using the phase difference is called an image plane phase difference detection method, and can be used for an autofocus function in an imaging device.

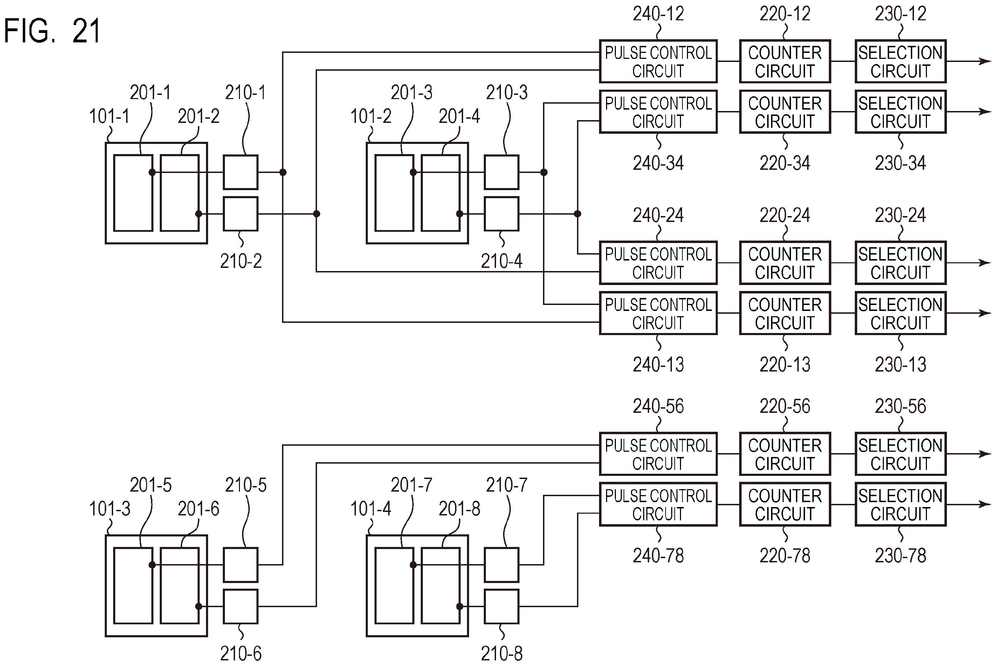

Fig. 21 is a block diagram illustrating a configuration example of a pixel circuit according to the present embodiment. Fig. 21 schematically illustrates an arrangement of counter circuits and the like with respect to four pixels 101-1, 101-2, 101-3, and 101-4 arranged in two rows and two columns. The pixel 101-1 includes APDs 201-1 and 201-2 (first avalanche photodiode and second avalanche photodiode). The pixel 101-2 includes APDs 201-3 and 201-4 (third avalanche photodiode and fourth avalanche photodiode). The pixel 101-3 includes APDs 201-5 and 201-6 (fifth avalanche photodiode and sixth avalanche photodiode), and the pixel 101-4 includes APDs 201-7 and 201-8.

The pixel circuit of Fig. 21 includes waveform shaping circuits 210-1 to 210-8 and pulse control circuits 240-12, 240-34, 240-24, 240-13, 240-56, and 240-78. Also, the pixel circuit in Fig. 21 includes counter circuits 220-12, 220-34, 220-24, 220-13, 220-56, and 220-78 and selection circuits 230-12, 230-34, 230-24, 230-13, 230-56, and 230-78. Since the function of each block is the same as that of the first embodiment to the third embodiment, the description thereof will be omitted.

The signals output from the APDs 201-1 to 201-8 are shaped by the waveform shaping circuits 210-1 to 210-8, respectively. The pulsed signal output from the waveform shaping circuit 210-1 is input to the pulse control circuits 240-12 and 240-13. The pulsed signal output from the waveform shaping circuit 210-2 is input to the pulse control circuits 240-12 and 240-24. The pulsed signal output from the waveform shaping circuit 210-3 is input to the pulse control circuits 240-34 and 240-13. The pulsed signal output from the waveform shaping circuit 210-4 is input to the pulse control circuits 240-34 and 240-24.

The pulsed signals output from the pulse control circuits 240-12, 240-34, 240-24, and 240-13 are input to the counter circuits 220-12, 220-34, 220-24, and 220-13, respectively. The selection circuits 230-12, 230-34, 230-24, and 230-13 output the count values held in the counter circuits 220-12, 220-34, 220-24, and 220-13 to the pixel output signal line 113, respectively.

The pulsed signals output from the waveform shaping circuits 210-5 and 210-6 are input to the pulse control circuit 240-56. The pulsed signals output from the waveform shaping circuits 210-7 and 210-8 are input to the pulse control circuit 240-78.

The pulsed signals output from the pulse control circuits 240-56 and 240-78 are input to the counter circuits 220-56 and 220-78, respectively. The selection circuits 230-56 and 230-78 output the count values held in the counter circuits 220-56 and 220-78 to the pixel output signal line 113, respectively.

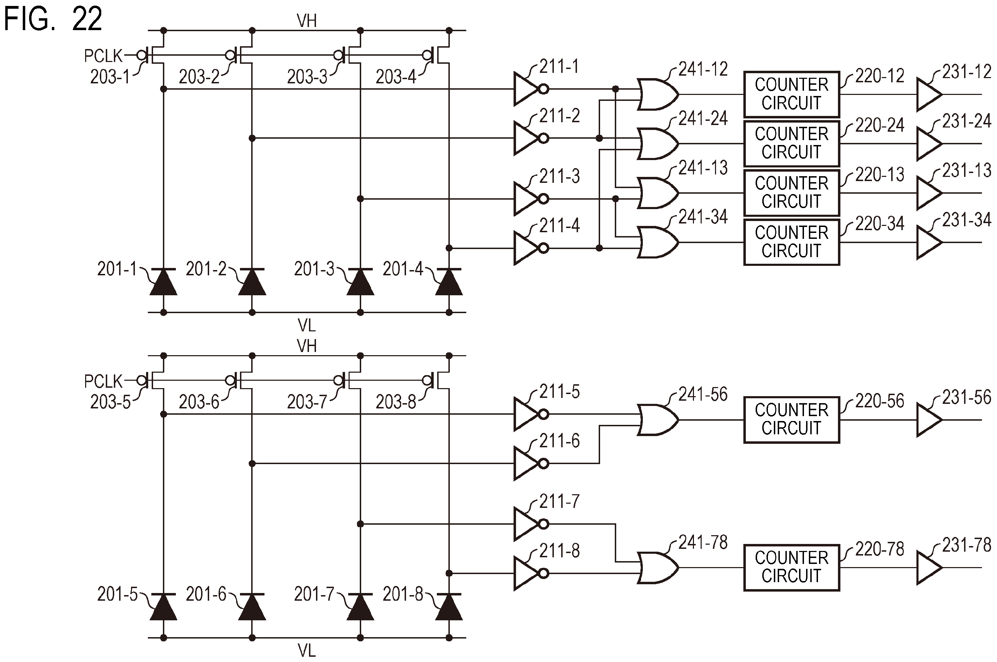

Fig. 22 is a circuit diagram illustrating a configuration example of the pixel circuit according to the present embodiment. Fig. 22 illustrates an example of a specific circuit corresponding to the block diagram illustrated in Fig. 21. The pixel circuit includes the APDs 201-1 to 201-8, transistors 203-1 to 203-8, inverters 211-1 to 211-8, and OR circuits 241-12, 241-24, 241-13, 241-34, 241-56, and 241-78. Also, the pixel circuit includes the counter circuits 220-12, 220-24, 220-13, 220-34, 220-56, and 220-78 and buffers 231-12, 231-24, 231-13, 231-34, 231-56, and 231-78.

In the circuit example of Fig. 22, the waveform shaping circuits 210-1 to 210-8 are constituted by the inverters 211-1 to 211-8, respectively. Also, the selection circuits 230-12, 230-24, 230-13, 230-34, 230-56, and 230-78 are constituted by the buffers 231-12, 231-24, 231-13, 231-34, 231-56, and 231-78, respectively. Also, the pulse control circuits 240-12, 240-24, 240-13, 240-34, 240-56, and 240-78 are constituted by the OR circuits 241-12, 241-24, 241-13, 241-34, 241-56, and 241-78, respectively.

The voltage VL is supplied to the anode of the APD 201-1. The cathode of the APD 201-1 is connected to the drain of the transistor 203-1 and the input terminal of the inverter 211-1. The voltage VH is supplied to the source of the transistor 203-1. The control clock signal PCLK is input to the gate of the transistor 203-1. The APDs 201-2 to 201-8, the transistors 203-2 to 203-8, and the inverters 211-2 to 211-8 are similarly connected.

The OR circuit 241-12 outputs a logical sum of the pulsed signal (first pulsed signal) output from the inverter 211-1 and the pulsed signal (second pulsed signal) output from the inverter 211-2 to the counter circuit 220-12 (third counter). The OR circuit 241-24 (second logic circuit) outputs a logical sum of the pulsed signal output from the inverter 211-2 and the pulsed signal (fourth pulsed signal) output from the inverter 211-4 to the counter circuit 220-24 (second counter). The OR circuit 241-13 (first logic circuit) outputs a logical sum of the pulsed signal output from the inverter 211-1 and the pulsed signal (third pulsed signal) output from the inverter 211-3 to the counter circuit 220-13 (first counter). The OR circuit 241-34 outputs a logical sum of the pulsed signal output from the inverter 211-3 and the pulsed signal output from the inverter 211-4 to the counter circuit 220-34 (fourth counter). The OR circuit 241-56 outputs a logical sum of the pulsed signal (fifth pulsed signal) output from the inverter 211-5 and the pulsed signal (sixth pulsed signal) output from the inverter 211-6 to the counter circuit 220-56 (fifth counter). The OR circuit 241-78 outputs a logical sum of the pulsed signal output from the inverter 211-7 and the pulsed signal output from the inverter 211-8 to the counter circuit 220-78.

The buffers 231-12, 231-24, 231-13, 231-34, 231-56, and 231-78 output count values of the counter circuits 220-12, 220-24, 220-13, 220-34, 220-56, and 220-78, respectively.

As described above, the four counter circuits 220-12, 220-34, 220-56, and 220-78 generate count values by counting the logical sum of the pulsed signals based on photons incident on the two APDs of the same pixel. Thus, the counter circuits 220-12, 220-34, 220-56, and 220-78 generates imaging signals. On the other hand, the two counter circuits 220-13 and 220-24 generate count values by counting the logical sum of the pulsed signals based on photons incident on the two APDs of the different pixels. These count values may be used for focus detection by the image plane phase difference detection method. Therefore, the counter circuits 220-13 and 220-24 generate the phase difference detection signals.

The pulsed signals based on photons incident on the APDs 201-5 and 201-6 are not input to counter circuits other than the counter circuit 220-56. Also, the pulsed signals based on photons incident on the APDs 201-7 and 201-8 are not input to counter circuits other than the counter circuit 220-78. That is, since the pulsed signals based on the incident photons to the APD 201-5, 201-6, 201-7, and 201-8 are not input to the counters other than the counters for the imaging signals, these pulsed signals are not used to generate the phase difference detection signals.

Also in the present embodiment, the photoelectric conversion device 100 capable of speeding up the signal processing in the same manner as in the first embodiment to the third embodiment is provided. Further, in the present embodiment, the effect of reducing the circuit scale and increasing the operation speed can be obtained for the following reasons.

A configuration in which each pixel circuit outputs both an imaging signal and phase difference detection signals based on incident photons to two APDs of one pixel can also be assumed as an example. On the other hand, in the present embodiment, the phase difference detection signals are acquired by counting the logical sum of the pulsed signals based on the photons incident on the two APDs 201-1 and 201-3 of different pixels. Similarly, phase difference detection signals are also acquired from the two APDs 201-2 and 201-4 of different pixels. Accordingly, since the phase difference detection signals of the two pixels are merged and output, the number of elements constituting the pulse control circuits, the counter circuits, and the selection circuits can be reduced, and the circuit scale can be reduced. In addition, since the number of times of generating and reading the phase difference detection signals are reduced, the operation of the photoelectric conversion device 100 can be speeded up. For example, when the photoelectric conversion device 100 has an autofocus function by a focus detection technique using a phase difference, the autofocus operation can be speeded up.

In addition, the phase difference detection signals are not acquired from the APD 201-5 to the APD 201-8, and a pulse control circuit, a counter circuit, and a selection circuit for acquiring the phase difference detection signals from the APD 201-5 to the APD 201-8 are not provided. Therefore, even in the case where the acquisition of the phase difference detection signals is thinned out in some pixels as described above, the effect of reducing the circuit scale and increasing the operation speed of the photoelectric conversion device 100 can be similarly obtained.

In the focus detection technique using the phase difference, sufficient accuracy may be obtained by the phase difference detection signals of some pixels even when the phase difference detection signals of all the pixels are not acquired. Therefore, as described above, even when the phase difference detection signals of a plurality of pixels are merged or the acquisition of the phase difference detection signals of some pixels is thinned out, the influence on the accuracy may be sufficiently suppressed.

### Fifth Embodiment

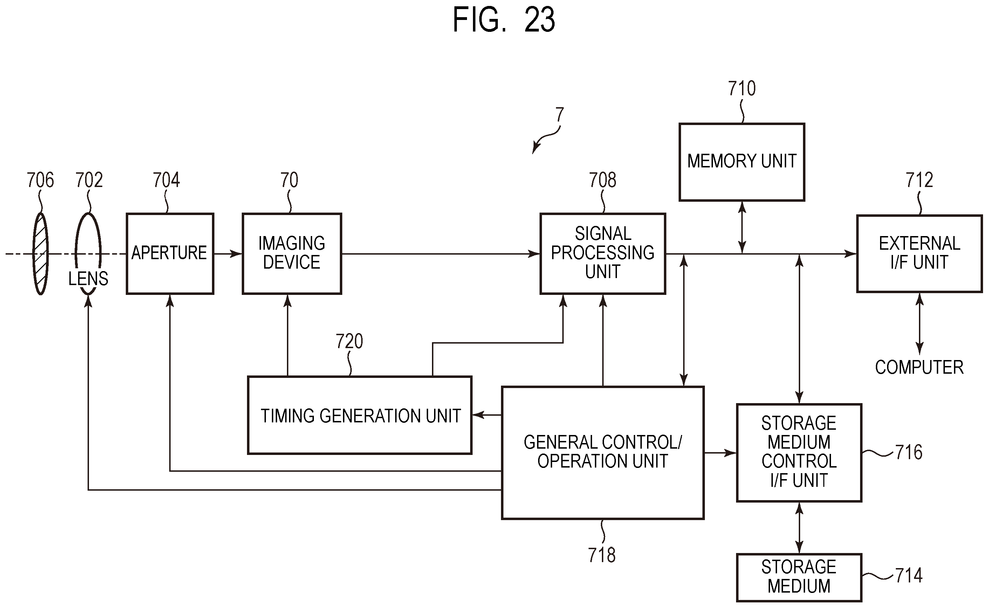

A photodetection system according to a fifth embodiment of the present disclosure will be described with reference to Fig. 23. Fig. 23 is a block diagram of a photodetection system according to the present embodiment. The photodetection system of the present embodiment is an imaging system that acquires an image based on incident light.

The photoelectric conversion device of the above-described embodiment may be applied to various imaging systems. Examples of the imaging system include a digital still camera, a digital camcorder, a camera head, a copying machine, a facsimile, a mobile phone, a vehicle-mounted camera, an observation satellite, and a surveillance camera. Fig. 23 is a block diagram of a digital still camera as an example of an imaging system.

The imaging system 7 illustrated in Fig. 23 includes a barrier 706, a lens 702, an aperture 704, an imaging device 70, a signal processing unit 708, a timing generation unit 720, a general control/operation unit 718, a memory unit 710, a storage medium control I/F unit 716, a storage medium 714, and an external I/F unit 712. The barrier 706 protects the lens, and the lens 702 forms an optical image of an object on the imaging device 70. The aperture 704 varies an amount of light passing through the lens 702. The imaging device 70 is configured as in the photoelectric conversion device of the above-described embodiment, and converts an optical image formed by the lens 702 into image data. The signal processing unit 708 performs various kinds of correction, data compression, and the like on the imaging data output from the imaging device 70.

The timing generation unit 720 outputs various timing signals to the imaging device 70 and the signal processing unit 708. The general control/operation unit 718 controls the entire digital still camera, and the memory unit 710 temporarily stores image data. The storage medium control I/F unit 716 is an interface for storing or reading out image data on the storage medium 714, and the storage medium 714 is a detachable storage medium such as a semiconductor memory for storing or reading out image data. The external I/F unit 712 is an interface for communicating with an external computer or the like. The timing signal or the like may be input from the outside of the imaging system 7, and the imaging system 7 may include at least the imaging device 70 and the signal processing unit 708 that processes an image signal output from the imaging device 70.

In the present embodiment, the imaging device 70 and the signal processing unit 708 may be arranged in the same semiconductor substrate. Further, the imaging device 70 and the signal processing unit 708 may be arranged in different semiconductor substrates.

Further, each pixel of the imaging device 70 may include a first photoelectric conversion unit and a second photoelectric conversion unit. The signal processing unit 708 processes a pixel signal based on a charge generated in the first photoelectric conversion unit and a pixel signal based on a charge generated in the second photoelectric conversion unit, and acquires the distance information from the imaging device 70 to the object.

### Sixth Embodiment

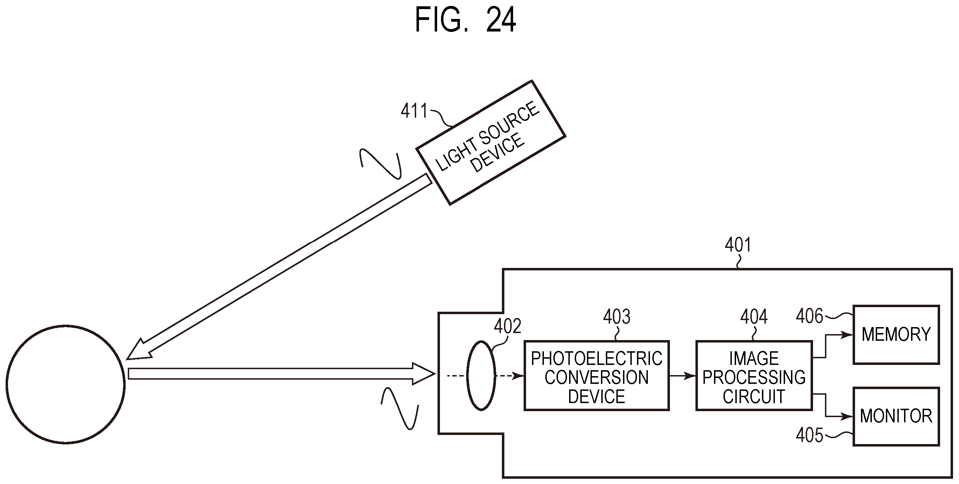

Fig. 24 is a block diagram of a photodetection system according to the present embodiment. More specifically, Fig. 24 is a block diagram of a distance image sensor using the photoelectric conversion device described in the above embodiment.

As illustrated in Fig. 24, the distance image sensor 401 includes an optical system 402, a photoelectric conversion device 403, an image processing circuit 404, a monitor 405, and a memory 406. The distance image sensor 401 receives light (modulated light or pulse light) emitted from the light source device 411 toward an object and reflected by the surface of the object. The distance image sensor 401 can acquire a distance image corresponding to a distance to the object based on a time period from light emission to light reception.

The optical system 402 includes one or a plurality of lenses, and guides image light (incident light) from the object to the photoelectric conversion device 403 to form an image on a light receiving surface (sensor unit) of the photoelectric conversion device 403.

As the photoelectric conversion device 403, the photoelectric conversion device of each of the embodiments described above can be applied. The photoelectric conversion device 403 supplies a distance signal indicating a distance obtained from the received light signal to the image processing circuit 404.

The image processing circuit 404 performs image processing for constructing a distance image based on the distance signal supplied from the photoelectric conversion device 403. The distance image (image data) obtained by the image processing can be displayed on the monitor 405 and stored (recorded) in the memory 406.

The distance image sensor 401 configured in this manner can acquire an accurate distance image by applying the photoelectric conversion device described above.

### Seventh Embodiment

The technology according to the present disclosure can be applied to various products. For example, the technology according to the present disclosure may be applied to an endoscopic surgical system, which is an example of a photodetection system.

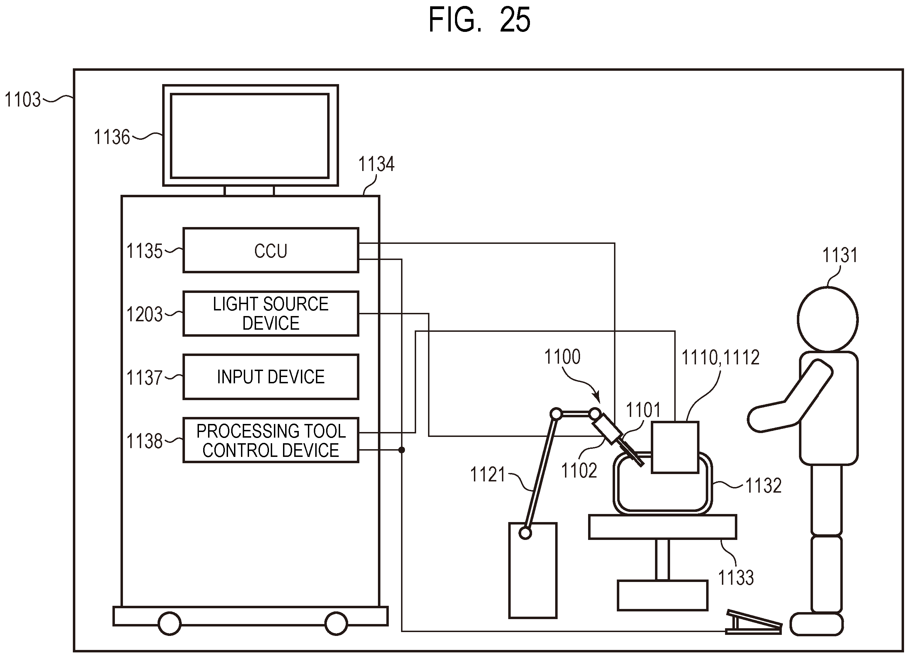

Fig. 25 is a schematic diagram of an endoscopic surgical system according to the present embodiment. Fig. 25 illustrates a state in which an operator (physician) 1131 performs surgery on a patient 1132 on a patient bed 1133 using an endoscopic surgical system 1103. As illustrated, the endoscopic surgical system 1103 includes an endoscope 1100, a surgical tool 1110, an arm 1121, and a cart 1134 on which various devices for endoscopic surgery are mounted.

The endoscope 1100 includes a barrel 1101 in which an area of a predetermined length from the distal end is inserted into a body cavity of a patient 1132, and a camera head 1102 connected to a proximal end of the barrel 1101. Fig. 25 illustrates an endoscope 1100 configured as a rigid scope having a rigid barrel 1101, but the endoscope 1100 may be configured as a flexible scope having a flexible barrel.

An opening into which an objective lens is fitted is provided at the distal end of the barrel 1101. A light source device 1203 is connected to the endoscope 1100. Light generated by the light source device 1203 is guided to the distal end of the barrel 1101 by a light guide extended inside the barrel 1101, and is irradiated to an observation target in the body cavity of the patient 1132 via an objective lens. The endoscope 1100 may be a straight-viewing scope an oblique-viewing scope, or a side-viewing scope.

An optical system and a photoelectric conversion device are provided inside the camera head 1102, and reflected light (observation light) from the observation target is focused on the photoelectric conversion device by the optical system. The observation light is photoelectrically converted by the photoelectric conversion device, and an electric signal corresponding to the observation light, that is, an image signal corresponding to an observation image is generated. As the photoelectric conversion device, the photoelectric conversion device described in each of the above embodiments can be used. The image signal is transmitted to a camera control unit (CCU) 1135 as RAW data.

The CCU 1135 includes a central processing unit (CPU), a graphics processing unit (GPU), and the like, and integrally controls operations of the endoscope 1100 and a display device 1136. Further, the CCU 1135 receives an image signal from the camera head 1102, and performs various types of image processing for displaying an image based on the image signal, such as development processing (demosaic processing).

The display device 1136 displays an image based on the image signal processed by the CCU 1135 under the control of the CCU 1135.

The light source device 1203 includes, for example, a light source such as a light emitting diode (LED), and supplies irradiation light to the endoscope 1100 when capturing an image of a surgical site or the like.

An input device 1137 is an input interface for the endoscopic surgical system 1103. The user can input various types of information and instructions to the endoscopic surgical system 1103 via the input device 1137.

A processing tool control device 1138 controls the actuation of the energy treatment tool 1112 for ablation of tissue, incision, sealing of blood vessels, and the like.

The light source device 1203 can supply irradiation light to the endoscope 1100 when capturing an image of a surgical site, and may be, for example, a white light source such as an LED, a laser light source, or a combination thereof. When a white light source is constituted by a combination of RGB laser light sources, the output intensity and output timing of each color (each wavelength) can be controlled with high accuracy. Therefore, the white balance of the captured image can be adjusted in the light source device 1203. In this case, laser light from each of the RGB laser light sources may be irradiated onto the observation target in a time-division manner, and driving of the imaging element of the camera head 1102 may be controlled in synchronization with the irradiation timing. Thus, images corresponding to R, G, and B can be captured in a time-division manner. According to such a method, a color image can be obtained without providing a color filter in the imaging element.

Further, the driving of the light source device 1203 may be controlled so that the intensity of the light output from the light source device 1203 is changed at predetermined time intervals. By controlling the driving of the imaging element of the camera head 1102 in synchronization with the timing of changing the intensity of light to acquire images in a time-division manner, and by synthesizing the images, it is possible to generate an image in a high dynamic range without so-called black out and white out.

Further, the light source device 1203 may be configured to be capable of supplying light in a predetermined wavelength band corresponding to special light observation. In the special light observation, for example, wavelength dependency of absorption of light in body tissue can be utilized. Specifically, predetermined tissues such as blood vessels in the surface layer of the mucosa are photographed with high contrast by irradiating light in a narrower band compared to the irradiation light (that is, white light) during normal observation. Alternatively, in the special light observation, fluorescence observation for obtaining an image by fluorescence generated by irradiation with excitation light may be performed. In the fluorescence observation, the body tissue can be irradiated with excitation light to observe fluorescence from the body tissue, or a reagent such as indocyanine green (ICG) can be locally injected to the body tissue and the body tissue can be irradiated with excitation light corresponding to the fluorescence wavelength of the reagent to obtain a fluorescence image. The light source device 1203 may be configured to supply narrowband light and/or excitation light corresponding to such special light observation.

### Eighth Embodiment

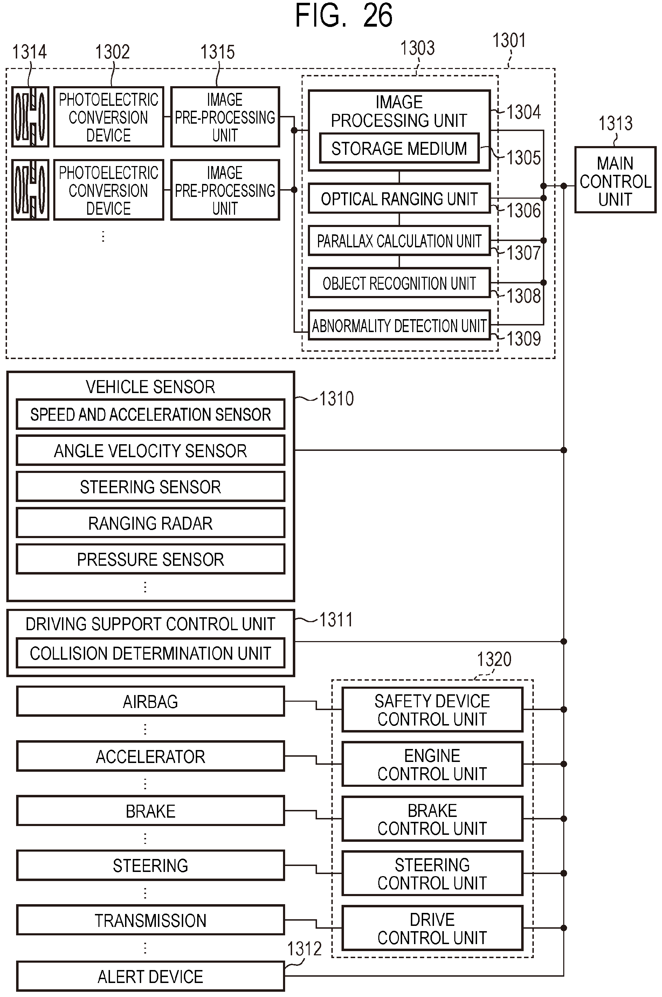

A photodetection system and a movable body of the present embodiment will be described with reference to Figs. 26, 27A, 27B, 27C, and 28. In the present embodiment, an example of an in-vehicle camera is illustrated as a photodetection system.

Fig. 26 is a schematic diagram of a photodetection system according to the present embodiment, and illustrates an example of a vehicle system and a photodetection system mounted on the vehicle system. The photodetection system 1301 includes photoelectric conversion devices 1302, image pre-processing units 1315, an integrated circuit 1303, and optical systems 1314. The optical system 1314 forms an optical image of an object on the photoelectric conversion device 1302. The photoelectric conversion device 1302 converts the optical image of the object formed by the optical system 1314 into an electric signal. The photoelectric conversion device 1302 is the photoelectric conversion device of any one of the above-described embodiments. The image pre-processing unit 1315 performs predetermined signal processing on the signal output from the photoelectric conversion device 1302. The function of the image pre-processing unit 1315 may be incorporated in the photoelectric conversion device 1302. The photodetection system 1301 is provided with at least two sets of the optical system 1314, the photoelectric conversion device 1302, and the image pre-processing unit 1315, and an output signal from the image pre-processing units 1315 of each set is input to the integrated circuit 1303.

The integrated circuit 1303 is an integrated circuit for use in an imaging system, and includes an image processing unit 1304 including a storage medium 1305, an optical ranging unit 1306, a parallax calculation unit 1307, an object recognition unit 1308, and an abnormality detection unit 1309. The image processing unit 1304 performs image processing such as development processing and defect correction on the output signal of the image pre-processing unit 1315. The storage medium 1305 performs primary storage of captured images and stores defect positions of image capturing pixels. The optical ranging unit 1306 focuses or measures the object. The parallax calculation unit 1307 calculates distance measurement information from the plurality of image data acquired by the plurality of photoelectric conversion devices 1302. The object recognition unit 1308 recognizes an object such as a car, a road, a sign, or a person. When the abnormality detection unit 1309 detects the abnormality of the photoelectric conversion device 1302, the abnormality detection unit 1309 issues an abnormality to the main control unit 1313.

The integrated circuit 1303 may be realized by dedicated hardware, a software module, or a combination thereof. It may be realized by a field programmable gate array (FPGA), an application specific integrated circuit (ASIC), or the like, or may be realized by a combination of these.

The main control unit 1313 controls overall operations of the photodetection system 1301, a vehicle sensor 1310, a control unit 1320, and the like. Without the main control unit 1313, the photodetection system 1301, the vehicle sensor 1310, and the control unit 1320 may individually have a communication interface, and each of them may transmit and receive control signals via a communication network, for example, according to the CAN standard.

The integrated circuit 1303 has a function of transmitting a control signal or a setting value to the photoelectric conversion device 1302 by receiving a control signal from the main control unit 1313 or by its own control unit.

The photodetection system 1301 is connected to the vehicle sensor 1310, and can detect a traveling state of the host vehicle such as a vehicle speed, a yaw rate, a steering angle, and the like, an environment outside the host vehicle, and states of other vehicles and obstacles. The vehicle sensor 1310 is also a distance information acquisition unit that acquires distance information to the object. The photodetection system 1301 is connected to a driving support control unit 1311 (movable body control unit) that performs various driving support functions such as an automatic steering function, an automatic cruise function, and a collision prevention function. In particular, with regard to the collision determination function, based on detection results of the photodetection system 1301 and the vehicle sensor 1310, it is determined whether or not there is a possibility or occurrence of collision with another vehicle or an obstacle. Thus, avoidance control is performed when a possibility of collision is estimated and a safety device is activated when collision occurs.

The photodetection system 1301 is also connected to an alert device 1312 that issues an alarm to a driver based on a determination result of the collision determination unit. For example, when the possibility of collision is high as the determination result of the collision determination unit, the main control unit 1313 performs vehicle control such as braking, returning an accelerator, suppressing engine output, or the like, thereby avoiding collision or reducing damage. The alert device 1312 issues a warning to a user using means such as an alarm of a sound or the like, a display of alarm information on a display unit screen such as a car navigation system and a meter panel, and a vibration application to a seatbelt and a steering wheel.

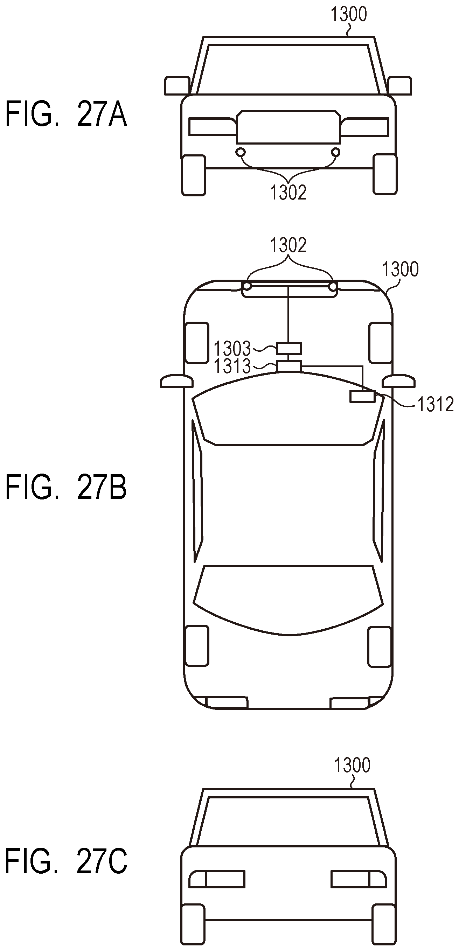

The photodetection system 1301 according to the present embodiment can capture an image around the vehicle, for example, the front or the rear. Figs. 27A, 27B, and 27C are schematic diagrams of a movable body according to the present embodiment, and illustrate a configuration in which an image of the front of the vehicle is captured by the photodetection system 1301.

The two photoelectric conversion devices 1302 are arranged in front of the vehicle 1300. Specifically, it is preferable that a center line with respect to a forward/backward direction or an outer shape (for example, a vehicle width) of the vehicle 1300 be regarded as a symmetry axis, and two photoelectric conversion devices 1302 be arranged in line symmetry with respect to the symmetry axis. This makes it possible to effectively acquire distance information between the vehicle 1300 and the object to be imaged and determine the possibility of collision. Further, it is preferable that the photoelectric conversion device 1302 be arranged at a position where it does not obstruct the field of view of the driver when the driver sees a situation outside the vehicle 1300 from the driver's seat. The alert device 1312 is preferably arranged at a position that is easy to enter the field of view of the driver.

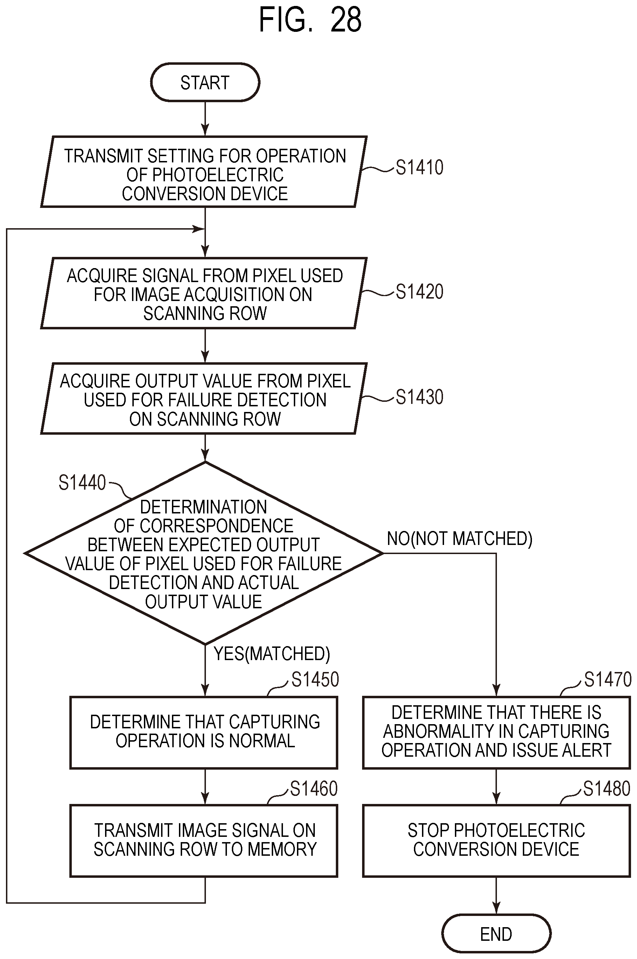

Next, a failure detection operation of the photoelectric conversion device 1302 in the photodetection system 1301 will be described with reference to Fig. 28. Fig. 28 is a flowchart illustrating an operation of the photodetection system according to the present embodiment. The failure detection operation of the photoelectric conversion device 1302 may be performed according to steps S1410 to S1480 illustrated in Fig. 28.

In step S1410, the setting at the time of startup of the photoelectric conversion device 1302 is performed. That is, setting information for the operation of the photoelectric conversion device 1302 is transmitted from the outside of the photodetection system 1301 (for example, the main control unit 1313) or the inside of the photodetection system 1301, and the photoelectric conversion device 1302 starts a capturing operation and a failure detection operation.

Next, in step S1420, the photoelectric conversion device 1302 acquires pixel signals from the effective pixels. In step S1430, the photoelectric conversion device 1302 acquires an output value from a failure detection pixel provided for failure detection. The failure detection pixel includes a photoelectric conversion element in the same manner as the effective pixel. A predetermined voltage is written to the photoelectric conversion element. The failure detection pixel outputs a signal corresponding to the voltage written in the photoelectric conversion element. Steps S1420 and S1430 may be executed in reverse order.

Next, in step S1440, the photodetection system 1301 performs a determination of correspondence between the expected output value of the failure detection pixel and the actual output value from the failure detection pixel. If it is determined in step S1440 that the expected output value matches the actual output value, the photodetection system 1301 proceeds with the process to step S1450, determines that the capturing operation is normally performed, and proceeds with the process to step S1460. In step S1460, the photodetection system 1301 transmits the pixel signals of the scanning row to the storage medium 1305 and temporarily stores them. Thereafter, the process of the photodetection system 1301 returns to step S1420 to continue the failure detection operation. On the other hand, as a result of the determination in step S1440, if the expected output value does not match the actual output value, the photodetection system 1301 proceeds with the process to step S1470. In step S1470, the photodetection system 1301 determines that there is an abnormality in the capturing operation, and issues an alert to the main control unit 1313 or the alert device 1312. The alert device 1312 causes the display unit to display that an abnormality has been detected. Then, in step S1480, the photodetection system 1301 stops the photoelectric conversion device 1302 and ends the operation of the photodetection system 1301.

Although the present embodiment exemplifies the example in which the flowchart is looped for each row, the flowchart may be looped for each plurality of rows, or the failure detection operation may be performed for each frame. The alert of step S1470 may be notified to the outside of the vehicle via a wireless network.

Further, in the present embodiment, the control in which the vehicle does not collide with another vehicle has been described, but the present embodiment is also applicable to a control in which the vehicle is automatically driven following another vehicle, a control in which the vehicle is automatically driven so as not to protrude from the lane, and the like. Further, the photodetection system 1301 can be applied not only to a vehicle such as a host vehicle, but also to a movable body (movable apparatus) such as a ship, an aircraft, or an industrial robot. In addition, the present embodiment can be applied not only to a movable body but also to an apparatus utilizing object recognition such as an intelligent transport systems (ITS).

The photoelectric conversion device of the present disclosure may be a configuration capable of further acquiring various types of information such as distance information.

### Ninth Embodiment

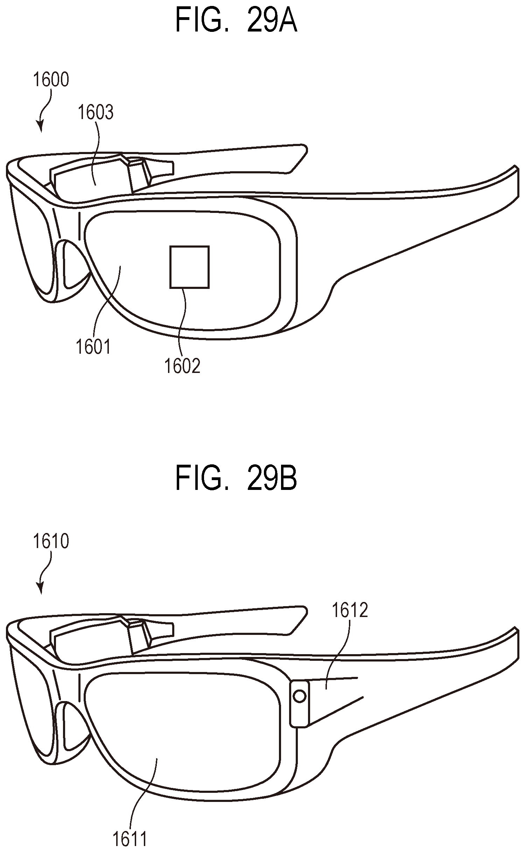

Fig. 29A is a diagram illustrating a specific example of an electronic device according to the present embodiment, and illustrates glasses 1600 (smart glasses). The glasses 1600 are provided with the photoelectric conversion device 1602 described in the above embodiments. That is, the glasses 1600 are an example of a photodetection system to which the photoelectric conversion device 1602 described in each of the above embodiments can be applied. A display device including a light emitting device such as an OLED or an LED may be provided on the back surface side of the lens 1601. One photoelectric conversion device 1602 or a plurality of photoelectric conversion devices 1602 may be provided. Further, a plurality of types of photoelectric conversion devices may be combined. The arrangement position of the photoelectric conversion device 1602 is not limited to that illustrated in Fig. 29A.

The glasses 1600 further comprise a control device 1603. The control device 1603 functions as a power source for supplying power to the photoelectric conversion device 1602 and the above-described display device. The control device 1603 controls operations of the photoelectric conversion device 1602 and the display device. The lens 1601 is provided with an optical system for collecting light to the photoelectric conversion device 1602.

Fig. 29B illustrates glasses 1610 (smart glasses) according to one application. The glasses 1610 include a control device 1612, and a photoelectric conversion device corresponding to the photoelectric conversion device 1602 and a display device are mounted on the control device 1612. The lens 1611 is provided with a photoelectric conversion device in the control device 1612 and an optical system for projecting light emitted from a display device, and an image is projected on the lens 1611. The control device 1612 functions as a power source for supplying power to the photoelectric conversion device and the display device, and controls operations of the photoelectric conversion device and the display device. The control device 1612 may include a line-of-sight detection unit that detects the line of sight of the wearer. Infrared radiation may be used to detect the line of sight. The infrared light emitting unit emits infrared light to the eyeball of the user who is watching the display image. The reflected light of the emitted infrared light from the eyeball is detected by an imaging unit having a light receiving element, whereby a captured image of the eyeball is obtained. A reduction unit that reduces light from the infrared light emitting unit to the display unit in a plan view may be employed and the reduction unit reduces a degradation in image quality.

The control device 1612 detects the line of sight of the user with respect to the display image from the captured image of the eyeball obtained by imaging the infrared light. Any known method can be applied to the line-of-sight detection using the captured image of the eyeball. As an example, a line-of-sight detection method based on a Purkinje image due to reflection of irradiation light at a cornea can be used.

More specifically, a line-of-sight detection process based on a pupil cornea reflection method is performed. By using the pupil cornea reflection method, a line-of-sight vector representing a direction (rotation angle) of the eyeball is calculated based on the image of the pupil included in the captured image of the eyeball and the Purkinje image, whereby the line-of-sight of the user is detected.

The display device of the present embodiment may include a photoelectric conversion device having a light receiving element, and may control a display image of the display device based on line-of-sight information of the user from the photoelectric conversion device.

Specifically, the display device determines a first view field region gazed by the user and a second view field region other than the first view field region based on the line-of-sight information. The first view field region and the second view field region may be determined by a control device of the display device, or may be determined by an external control device. In the display area of the display device, the display resolution of the first view field region may be controlled to be higher than the display resolution of the second view field region. That is, the resolution of the second view field region may be lower than that of the first view field region.

The display area may include a first display region and a second display region different from the first display region. A region having a high priority may be determined from the first display region and the second display region based on the line-of-sight information. The first view field region and the second view field region may be determined by a control device of the display device, or may be determined by an external control device. The resolution of the high priority area may be controlled to be higher than the resolution of the region other than the high priority region. That is, the resolution of a region having a relatively low priority can be reduced.

It should be noted that an artificial intelligence (AI) may be used in determining the first view field region and the region with high priority. The Al may be a model configured to estimate an angle of a line of sight and a distance to a target on the line-of-sight from an image of an eyeball, and the AI may be trained using training data including images of an eyeball and an angle at which the eyeball in the images actually gazes. The Al program may be provided in either a display device or a photoelectric conversion device, or may be provided in an external device. When the external device has the AI program, the Al program may be transmitted from a server or the like to a display device via communication.

When the display control is performed based on the line-of-sight detection, the present embodiment can be preferably applied to smart glasses which further include a photoelectric conversion device for capturing an image of the outside. The smart glasses can display captured external information in real time.

### Tenth Embodiment

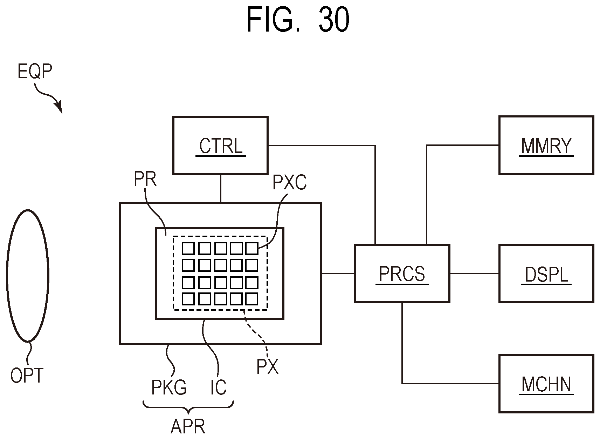

Equipment according to a tenth embodiment will be described with reference to Fig. 30. Fig. 30 is a block diagram illustrating a schematic configuration of equipment according to the present embodiment.

Fig. 30 is a schematic diagram illustrating equipment EQP including a photoelectric conversion device APR. The photoelectric conversion device APR has the function of the photoelectric conversion device 100 according to the first to fourth embodiments. All or part of the photoelectric conversion device APR is a semiconductor device IC. The photoelectric conversion device APR of this example can be used as, for example, an image sensor, an auto focus (AF) sensor, a photometric sensor, a ranging sensor, or the like. The semiconductor device IC has a pixel area PX in which pixel circuits PXC each including photoelectric conversion unit are arranged in a matrix. The semiconductor device IC may have a peripheral area PR around the pixel area PX. Circuits other than the pixel circuits can be arranged in the peripheral area PR.

The photoelectric conversion device APR may have a structure (stacked chips structure) in which a first semiconductor chip provided with a plurality of photoelectric conversion units and a second semiconductor chip provided with a peripheral circuit are stacked. Each of the peripheral circuits in the second semiconductor chip may be a column circuit corresponding to a pixel column of the first semiconductor chip. Each of the peripheral circuits in the second semiconductor chip may be a matrix circuit corresponding to a pixel or a pixel block in the first semiconductor chip. For the connection between the first semiconductor chip and the second semiconductor chip, a through electrode (TSV), an interchip wiring by direct bonding of a conductor such as copper, a connection by a micro bump between chips, a connection by wire bonding, or the like can be employed.

The photoelectric conversion device APR may include a package PKG for mounting the semiconductor device IC in addition to the semiconductor device IC. The package PKG may include a base body to which the semiconductor device IC is fixed, a lid such as glass facing the semiconductor device IC, and a connection member such as a bonding wire or a bump for connecting a terminal provided on the base body and a terminal provided on the semiconductor device IC.

The equipment EQP may further include at least one of an optical device OPT, a control device CTRL, a processing device PRCS, a display device DSPL, a storage device MMRY, and a mechanical device MCHN. The optical device OPT corresponds to the photoelectric conversion device APR, and is, for example, a lens, a shutter, or a mirror. The control device CTRL controls the photoelectric conversion device APR, and is, for example, a semiconductor device such as an ASIC.

The processing device PRCS processes a signal output from the photoelectric conversion device APR, and constitutes an analog front end (AFE) or a digital front end (DFE). The processing device PRCS is a semiconductor device such as a central processing unit (CPU) or an application specific integrated circuit (ASIC). The display device DSPL is an EL display device, a liquid crystal display device, or the like that displays information (image) obtained by the photoelectric conversion device APR. The storage device MMRY is a magnetic device, a semiconductor device, or the like that stores information (image) obtained by the photoelectric conversion device APR. The storage device MMRY is a volatile memory such as an SRAM or a DRAM, or a nonvolatile memory such as a flash memory or a hard disk drive.

The mechanical device MCHN includes a movable portion or a propulsion portion such as a motor or an engine. In the equipment EQP, a signal output from the photoelectric conversion device APR is displayed on the display device DSPL or transmitted to the outside by a communication device (not illustrated) included in the equipment EQP. Therefore, it is preferable that the equipment EQP further include a storage device MMRY and a processing device PRCS separately from the storage circuit unit and the arithmetic circuit unit included in the photoelectric conversion device APR. The mechanical device MCHN may be controlled based on a signal output from the photoelectric conversion device APR.

The equipment EQP illustrated in Fig. 30 may be an electronic device such as an information terminal (for example, a smartphone and a wearable terminal) having a photographing function, a camera (For example, an interchangeable lens camera, a compact camera, a video camera, and a surveillance camera), or the like. The mechanical device MCHN in the camera may drive parts of the optical device OPT for zooming, focusing, and shutter operation. Also, the equipment EQP may be a transport device (movable body) such as a vehicle, a ship, a drone, or an airplane. The equipment EQP may be a medical device such as an endoscope or a CT scanner. The equipment EQP may be a measurement device such as a ranging sensor, an analysis device such as an electron microscope, an office device such as a copier, or an industrial device such as a robot.

The mechanical device MCHN in the transport device may be used as a movable device. The equipment EQP as a transport device is suitable for transporting the photoelectric conversion device APR, or for assisting and/or automating driving (manipulation) by an imaging function. The processing device PRCS for assisting and/or automating driving (manipulation) may perform processing for operating the mechanical device MCHN as a movable device based on information obtained by the photoelectric conversion device APR.

According to the first to fourth embodiments, signal acquisition can be performed satisfactorily. Therefore, the photoelectric conversion device APR according to the first to fourth embodiments may provide a high value to a designer, a manufacturer, a seller, a purchaser, and/or a user thereof. Therefore, when the photoelectric conversion device APR is mounted on the equipment EQP, the value of the equipment EQP may also be increased. Therefore, in manufacturing and selling the equipment EQP, it is advantageous to determine the mounting of the photoelectric conversion device APR of the present embodiment on the equipment EQP in order to increase the value of the equipment EQP. Here, increasing the value corresponds to at least one of adding a function, improving performance, improving characteristics, improving reliability, improving manufacturing yield, reducing environmental load, reducing cost, reducing size, and reducing weight.

For example, by mounting the photoelectric conversion device APR in a transport device, it is possible to obtain excellent performance when photographing outside the transport device or measuring an external environment. Therefore, in manufacturing and selling the transport device, it is advantageous to determine the mounting of the photoelectric conversion device APR according to the present embodiment on the transport device in order to improve the performance of the transport device itself. In particular, the photoelectric conversion device APR is suitable for a transport device that performs driving support and/or automatic driving of the transport device using information obtained by the photoelectric conversion device APR.

### Other Embodiments

The present disclosure is not limited to the above embodiments, and various modifications are possible. For example, an example in which some of the configurations of any one of the embodiments are added to other embodiments or an example in which some of the configurations of any one of the embodiments are replaced with some of the configurations of other embodiments are also embodiments of the present disclosure.

The embodiments described above can be appropriately modified without departing from the technical idea. Note that the disclosure of the present specification includes not only the matters described in the present specification but also all matters that can be grasped from the present specification and the drawings attached to the present specification. Also, the disclosure of the present specification includes a complementary set of the concepts described in the present specification. In other words, for example, when there is a description of "A is greater than B" in the present specification, it can be said that the description of "A is not greater than B" is disclosed in the present specification even when the description of "A is not greater than B" is omitted. This is because it is assumed that the case where "A is not greater than B" is considered when "A is greater than B" is described.

Embodiment(s) of the present disclosure can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiment(s) and/or that includes one or more circuits (e.g., application specific integrated circuit (ASIC)) for performing the functions of one or more of the above-described embodiment(s), and by a method performed by the computer of the system or apparatus by, for example, reading out and executing the computer executable instructions from the storage medium to perform the functions of one or more of the above-described embodiment(s) and/or controlling the one or more circuits to perform the functions of one or more of the above-described embodiment(s). The computer may comprise one or more processors (e.g., central processing unit (CPU), micro processing unit (MPU)) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory (ROM), a storage of distributed computing systems, an optical disk (such as a compact disc (CD), digital versatile disc (DVD), or Blu-ray Disc (BD)^{™}), a flash memory device, a memory card, and the like.

It should be noted that the above-described embodiments are merely specific examples for carrying out the present disclosure, and the technical scope of the present disclosure should not be interpreted in a limited manner by these embodiments. That is, the present disclosure can be implemented in various forms without departing from the technical idea or the main features thereof.

Various embodiments have been described in detail above but it will be understood that the present disclosure is not limited to these embodiments and encompasses all modifications, variants, alternatives and equivalents falling within the scope of the appended claims.

## Claims

1. A photoelectric conversion device (100) comprising:
a plurality of avalanche photodiodes (201-1, 201-2);
a first counter (220-1) configured to count a first pulsed signal based on a photon incident on a first avalanche photodiode (201-1) of the plurality of avalanche photodiodes (201-1, 201-2);
a second counter (220-2) configured to count a second pulsed signal based on a photon incident on a second avalanche photodiode (201-2) of the plurality of avalanche photodiodes (201-1, 201-2); and
a third counter (220-12) configured to count a combined pulsed signal generated by combining the first pulsed signal and the second pulsed signal.

2. The photoelectric conversion device according to claim 1, wherein an operation of reading the first counter and the second counter and an operation of reading the third counter are performed simultaneously.

3. The photoelectric conversion device according to claim 1, wherein an operation of reading the first counter and the second counter and an operation of reading the third counter are performed at different timings.

4. The photoelectric conversion device according to any one of claims 1 to 3, wherein a length of a period during which the third counter counts the combined pulsed signal is shorter than any of a length of a period during which the first counter counts the first pulsed signal and a length of a period during which the second counter counts the second pulsed signal.

5. The photoelectric conversion device according to claim 1, wherein one of an operation of reading the first counter and the second counter and an operation of reading the third counter is performed.

6. The photoelectric conversion device according to any one of claims 1 to 5, wherein the number of bits of the third counter is greater than either the number of bits of the first counter or the number of bits of the second counter.

7. The photoelectric conversion device according to any one of claims 1 to 6 further comprising an OR circuit configured to output a logical sum of the first pulsed signal and the second pulsed signal to the third counter as the combined pulsed signal.

8. The photoelectric conversion device according to any one of claims 1 to 6 further comprising an XOR circuit configured to output an exclusive OR of the first pulsed signal and the second pulsed signal to the third counter as the combined pulsed signal.

9. The photoelectric conversion device according to any one of claims 1 to 8 further comprising a count control circuit configured to control at least one of the first counter, the second counter, and the third counter so that when one photon is incident, a different value is counted according to an incident timing.

10. The photoelectric conversion device according to any one of claims 1 to 9 further comprising a plurality microlenses,
wherein two of the plurality of microlenses are arranged to guide photons incident thereon to the first avalanche photodiode and the second avalanche photodiode, respectively.

11. The photoelectric conversion device according to any one of claims 1 to 9 further comprising a plurality microlenses,
wherein one of the plurality of microlenses is arranged to guide a photon incident thereon to the first avalanche photodiode and the second avalanche photodiode.

12. The photoelectric conversion device according to any one of claims 1 to 10,
wherein the plurality of avalanche photodiodes further includes a seventh avalanche photodiode and an eighth avalanche photodiode,
wherein the combined pulsed signal is generated further based on a seventh pulsed signal based on a photon incident on the seventh avalanche photodiode and an eighth pulsed signal based on a photon incident on the eighth avalanche photodiode.

13. The photoelectric conversion device according to claim 12,
wherein a color filter is arranged on each of the plurality of avalanche photodiodes, and
wherein color filters respectively arranged on the first avalanche photodiode, the second avalanche photodiode, the seventh avalanche photodiode, and the eighth avalanche photodiode have a same color.

14. The photoelectric conversion device according to claim 13,
wherein the plurality of avalanche photodiodes are arranged to form a plurality of rows and a plurality of columns, and
wherein the first avalanche photodiode, the second avalanche photodiode, the seventh avalanche photodiode, and the eighth avalanche photodiode are arranged to form two rows adjacent to each other and two columns adjacent to each other.

15. Equipment comprising:
the photoelectric conversion device according to any one of claims 1 to 14; and
at least any one of:
an optical device adapted for the photoelectric conversion device,
a control device configured to control the photoelectric conversion device,
a processing device configured to process a signal output from the photoelectric conversion device,
a display device configured to display information obtained by the photoelectric conversion device,
a storage device configured to store information obtained by the photoelectric conversion device, and
a mechanical device configured to operate based on information obtained by the photoelectric conversion device.
